(19) Europäisches Patentamt / European Patent Office / Office européen des brevets

(11) **EP 4 502 634 A1**

(12) **EUROPEAN PATENT APPLICATION**
published in accordance with Art. 153(4) EPC

(43) Date of publication:
05.02.2025 Bulletin 2025/06

(21) Application number: 23778992.0

(22) Date of filing: 16.02.2023

(51) International Patent Classification (IPC):
$G01R\ 31/392^{(2019.01)}$    $G01R\ 31/374^{(2019.01)}$
$G01R\ 31/382^{(2019.01)}$    $G01R\ 31/385^{(2019.01)}$
$G01R\ 31/387^{(2019.01)}$    $G01R\ 31/389^{(2019.01)}$
$H01M\ 10/48^{(2006.01)}$    $H02J\ 7/00^{(2006.01)}$

(52) Cooperative Patent Classification (CPC):
G01R 31/374; G01R 31/382; G01R 31/385;
G01R 31/387; G01R 31/389; G01R 31/392;
H01M 10/48; H02J 7/00; Y02E 60/10

(86) International application number:
PCT/JP2023/005613

(87) International publication number:
WO 2023/188962 (05.10.2023 Gazette 2023/40)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 29.03.2022 JP 2022052949

(71) Applicant: Hitachi Construction Machinery Co.,
Ltd.
Tokyo 110-0015 (JP)

(72) Inventors:
• KAMIJIO Takashi
Tokyo 100-8280 (JP)

• KOMATSU Daiki
Tokyo 100-8280 (JP)
• TANIGAKI Kenta
Tsuchiura-shi, Ibaraki 300-0013 (JP)
• MAKIMURA Yuki
Tsuchiura-shi, Ibaraki 300-0013 (JP)
• TAKEUCHI Ken
Tsuchiura-shi, Ibaraki 300-0013 (JP)

(74) Representative: MERH-IP Matias Erny Reichl
Hoffmann
Patentanwälte PartG mbB
Paul-Heyse-Straße 29
80336 München (DE)

(54) **BATTERY DIAGNOSTIC SYSTEM**

(57) A battery diagnosis system includes a controller that obtains operation data of a power storage device including a plurality of secondary battery cells, computes a battery state value on the basis of the obtained operation data, and diagnoses a state of the power storage device on the basis of the computed battery state value, and an output device that outputs a result of the diagnosis of the power storage device performed by the controller. The operation data includes a minimum value and a maximum value of cell voltages of the plurality of secondary battery cells constituting the power storage device. The controller computes a minimum cell capacity or a maximum cell resistance as the battery state value on the basis of the minimum value of the cell voltages measured when a charge/discharge state of the power storage device is a first state and the maximum value of the cell voltages measured when the charge/discharge state of the power storage device is a second state.

**(Cont. next page)**

## FIG. 5

START

S500 — DETERMINE DATA OBTAINMENT TIMING BEFORE CHARGE
(IS BATTERY PACK IN NO-LOAD STATE?)

S501 — OBTAIN CELL VOLTAGE MINIMUM VALUE BEFORE CHARGE

S502 — COMPUTE SOCmin1

S503 — COMPUTE CHARGING CHARGE AMOUNT ΔQc DURING CHARGE

S504 — DETERMINE DATA OBTAINMENT TIMING AFTER CHARGE
(IS BATTERY PACK IN NO-LOAD STATE?)

S505 — OBTAIN CELL VOLTAGE MAXIMUM VALUE AFTER CHARGE

S506 — COMPUTE SOCmax2

S507 — IS DIAGNOSIS EXECUTION CONDITION SATISFIED? — No

Yes

S508 — COMPUTE SOC MAXIMUM CHANGE AMOUNT ΔSOCmax
COMPUTE MINIMUM CELL CAPACITY Qmin

S509 — Qmin < Qmin0 ? — No

Yes

S510 — DETERMINE THAT ABNORMALLY DEGRADED BATTERY CELL HAS OCCURRED

END

**Description**

Technical Field

The present invention relates to a battery diagnosis system.

Background Art

An effort has recently been made to electrify a power source mounted in a work machine such as a hydraulic excavator. The electrification of the power source is achieved by using a power storage device storing electric power as a power supply, and driving an electric motor mounted in the work machine by electric power supplied from the power storage device. The power storage device includes a plurality of secondary battery cells of a lithium ion battery, a lead storage battery, or the like.

In the work machine including the electrified power source, a larger size of the power storage device, that is, serialization and parallelization of multiple battery cells, is desired for a longer period of operation time and a larger size of a machine body. The battery cells have differences in degradation speed due to individual differences in performance and differences in a usage environment such as temperature. Hence, increasing the size of the power storage device increases risks of degradation variation between the battery cells and the occurrence of an abnormally degraded battery cell. When an abnormality such as a decrease in the voltage of the power storage device occurs in a battery system due to the abnormal degradation of a battery cell during work of the work machine, the work machine is stopped, and the work cannot be continued. A technology for preventing the occurrence of an abnormality in the battery system is therefore important.

A method of analyzing information about all of the battery cells constituting the power storage device is effective in order to analyze a degraded state of a most degraded battery cell in the power storage device including the plurality of battery cells. However, this method invites an increase in computation processing of a controller of the battery system. Therefore, the increase in the computation processing may be suppressed by limiting information used for the analysis in the information about the battery cells such as cell voltages and cell temperatures to a maximum value, a minimum value, and an average value or the like. Patent Document 1 discloses a storage battery state evaluation system that evaluates the state of a storage battery system including a plurality of battery cells by using a maximum value, a minimum value, and an average value of the battery cells.

The storage battery state evaluation system described in Patent Document 1 includes a memory that holds, among the voltages of the plurality of battery cells, the voltages of at least two battery cells at different positions in a distribution of the voltages of the plurality of battery cells, and computes the inclinations of the voltages with respect to time in an idle period after the discharge of the at least two battery cells.

The storage battery state evaluation system described in Patent Document 1 calculates the degraded states of the battery cells on the basis of the inclinations (time differential values) of a maximum value, a minimum value, and an average value of two cell voltages in the battery system. The storage battery state evaluation system described in Patent Document 1 calculates a distribution of the degraded states of the plurality of battery cells on the basis of the degraded states of the plurality of battery cells and the positions in the distribution of the voltages of the plurality of battery cells.

Prior Art Document

Patent Document

Patent Document 1: JP-2020-169943-A

Summary of the Invention

Problem to be Solved by the Invention

However, in the power storage device, there may occur an abnormally degraded battery cell whose voltage changes greatly due to a charge or a discharge. The abnormally degraded battery cell whose voltage changes greatly may have a lowest voltage before the charge and have a highest voltage after the charge among the plurality of battery cells. In this case, the degraded state of the battery cell is underestimated in a battery diagnosis system that diagnoses the degraded states of the battery cells of the power storage device on the basis of a temporal change in the maximum value or a temporal change in the minimum value of the battery cells in the power storage device, as in the technology described in Patent Document 1. Hence, the technology described in Patent Document 1 may erroneously evaluate the power storage device as normal even though the abnormally degraded battery cell whose voltage changes greatly has occurred in the power storage device.

It is an object of the present invention to provide a battery diagnosis system that can appropriately diagnose the state of a power storage device while suppressing an increase in a load of computation processing on a controller.

Means for Solving the Problem

A battery diagnosis system according to one aspect of the present invention includes a controller configured to obtain operation data of a power storage device including a plurality of secondary battery cells, compute a battery state value on the basis of the obtained operation data, and diagnose a state of the power storage device on the basis of the computed battery state value, and an output device that outputs a result of the diagnosis of the power storage device performed by the controller. The operation data includes a minimum value and a maximum value of cell voltages of the plurality of secondary battery cells constituting the power storage device. The controller computes a minimum cell capacity or a maximum cell resistance as the battery state value on the basis of the minimum value of the cell voltages measured when a charge/discharge state of the power storage device is a first state and the maximum value of the cell voltages measured when the charge/discharge state of the power storage device is a second state.

Advantages of the Invention

According to the present invention, it is possible to provide a battery diagnosis system that can appropriately diagnose the state of a power storage device while suppressing an increase in a load of computation processing on a controller.

Brief Description of the Drawings

FIG. 1 is a perspective view of a work machine according to a first embodiment of the present invention.
FIG. 2 is a block diagram illustrating an example of a battery system mounted in the work machine of FIG. 1.
FIG. 3 is a functional block diagram of assistance in explaining a battery diagnosing function of a VCU in FIG. 2.
FIG. 4 is a diagram illustrating an example of temporal changes in the SOC of a minimum capacity cell during a charge.
FIG. 5 is a flowchart of assistance in explaining an example of a flow of battery diagnosis processing performed by the VCU.
FIG. 6 is a diagram of assistance in explaining the case of a first example in which an erroneous diagnosis tends to be made.
FIG. 7 is a diagram of assistance in explaining the case of a second example in which an erroneous diagnosis tends to be made.
FIG. 8 is a diagram illustrating an example of temporal changes in cell voltage during a discharge.
FIG. 9 is a flowchart of assistance in explaining an example of a flow of battery diagnosis processing performed by the VCU.
FIG. 10 is a diagram illustrating an example of actually measured values and an approximate equation of a battery state value.

Modes for Carrying Out the Invention

Embodiments of the present invention will be described with reference to the drawings.

[First Embodiment]

<Configuration of Work Machine>

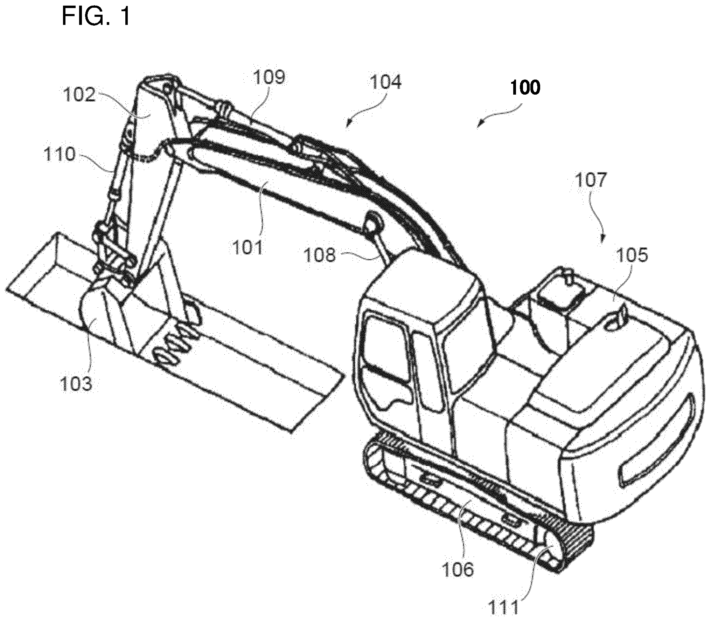

FIG. 1 is a perspective view of a work machine 100 according to a first embodiment of the present invention. As illustrated in FIG. 1, the work machine 100 according to the present embodiment is a hydraulic excavator. It is to be noted that the work machine 100 is not limited to the hydraulic excavator and may be, for example, a wheel loader, a dump truck, or a road machine. As illustrated in FIG. 1, the work machine 100 includes a machine body 107 and a work device 104 attached to the machine body 107.

The machine body 107 includes a lower track structure 106 having crawlers, and an upper swing structure 105 swingably attached to the lower track structure 106. The lower track structure 106 has left and right travelling motors 111 as hydraulic motors. These travelling motors 111 rotate the crawlers to make the work machine 100 travel. The upper swing structure 105 is driven by a swing motor (not illustrated) as an electric motor and is thereby swung with respect to the lower track structure 106.

The work device 104 is an articulated front work implement attached to a front portion of the machine body 107. The work device 104 includes a boom 101, an arm 102, and a bucket 103. The work device 104 is driven by a boom cylinder 108, an arm cylinder 109, and a bucket cylinder 110 as hydraulic cylinders and thereby performs work such as excavation work or loading work.

The machine body 107 is mounted with a hydraulic pump that delivers a hydraulic operating fluid as well as control valves that control the directions and flow rates of the hydraulic operating fluid supplied from the hydraulic pump to hydraulic actuators such as the hydraulic cylinders and the hydraulic motors.

The directions and flow rates of the hydraulic operating fluid delivered from the hydraulic pump are controlled by the control valves, and the operations of the boom cylinder 108, the arm cylinder 109, the bucket cylinder 110, and the left and right travelling motors 111 are thus controlled.

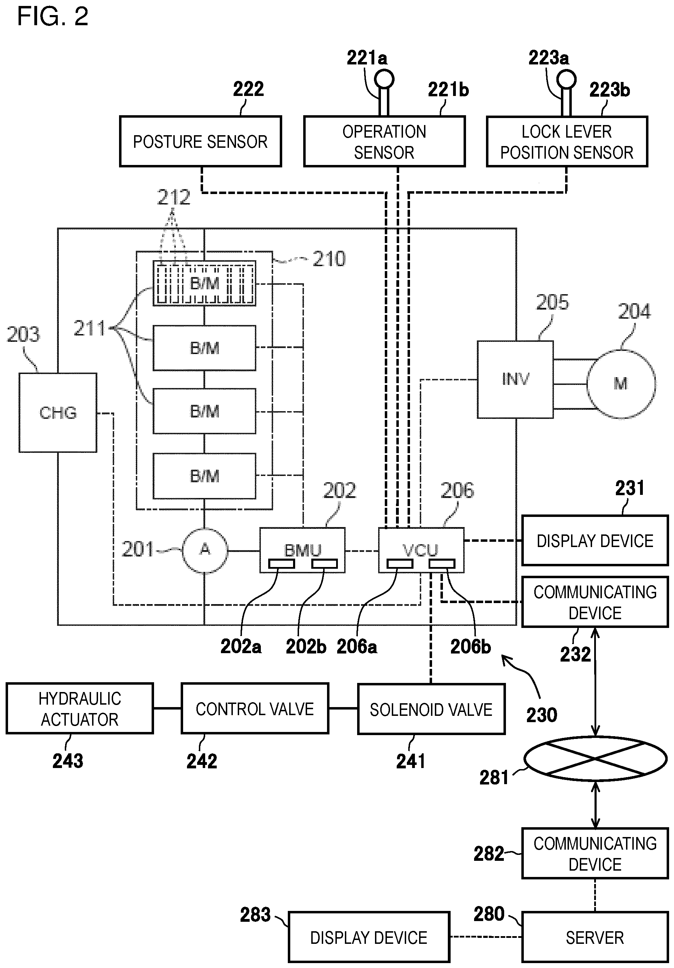

The machine body 107 is mounted with an electric motor 204 (see FIG. 2) that drives the hydraulic pump, and a battery system 200 (see FIG. 2) that supplies electric power to the electric motor 204 and controls the driving of the electric motor 204.

<Configuration of Battery System>

FIG. 2 is a block diagram illustrating an example of the battery system 200 mounted in the work machine 100 of FIG. 1. As illustrated in FIG. 2, the battery system 200 includes a battery pack 210, an ammeter 201, a BMU: Battery Management Unit 202, a charger 203, the electric motor 204, an inverter 205, and a VCU: Vehicle Control Unit 206.

The battery pack 210 includes a plurality of battery modules 211 connected in series with each other. Incidentally, the plurality of battery modules 211 may be connected in parallel with each other or may be connected in series and in parallel with each other. Each of the battery modules 211 is constituted by a plurality of secondary battery cells (hereinafter written simply as battery cells) 212. The plurality of battery cells 212 constituting the battery module 211 are connected in series with each other. Each of the battery cells 212 is a lithium ion battery, for example. That is, the battery pack 210 is a power storage device including the plurality of battery cells 212.

The ammeter 201 is, for example, connected in series with the plurality of battery modules 211 connected in series with each other. The ammeter 201 senses a current value I of a current that flows through each of the battery cells 212. In a case where the plurality of battery modules 211 are connected in parallel with each other, one ammeter 201 is installed for each of the plurality of battery modules 211 to sense the current value I of the current that flows through the battery cells 212 constituting each of the battery modules 211. The ammeter 201 outputs a signal indicating a sensing result to the BMU 202.

The BMU 202 is a microcontroller including a processing device 202a and a storage device 202b. The processing device 202a is, for example, a CPU (Central Processing Unit), an MPU (Micro Processing Unit), a DSP (Digital Signal Processor), or the like. The storage device 202b is a nonvolatile memory such as a ROM (Read Only Memory), a flash memory, and a hard disk drive or a volatile memory generally called a RAM (Random Access Memory).

The BMU 202 is connected to each of the battery modules 211 of the battery pack 210 via wiring. The BMU 202 monitors the states of the battery cells 212 constituting each of the battery modules 211. The BMU 202 senses the voltage and temperature of each battery cell 212 and stores the voltage and temperature of each battery cell 212 in the storage device 202b. The BMU 202 stores and manages a data log indicating an operation history of the battery pack 210 (which data log will hereinafter be described also as operation data). Incidentally, in the following, the voltages of the battery cells 212 will be described also as cell voltages, and the temperatures of the battery cells 212 will be described also as cell temperatures.

The operation data of the battery pack 210 stored in the BMU 202 includes, for example, time, the cell voltages, the cell temperatures, and a current value. In addition, the BMU 202 computes an SOC: state of charge (charging rate) and an SOH: state of health (degradation rate) of the battery pack 210 as a whole.

The charger 203 is connected to the battery pack 210. The charger 203 is, for example, connected to an external power supply (not illustrated) and charges the battery pack 210. The inverter 205 converts direct-current power supplied from the battery pack 210 into alternating-current power and supplies the alternating-current power to the electric motor 204. The electric motor 204 is driven by the power supplied from the battery pack 210 and thereby drives the hydraulic pump to generate the power of the work machine 100.

The VCU 206 is a microcontroller including a processing device 206a and a storage device 206b. The processing device 206a is, for example, a CPU (Central Processing Unit), an MPU (Micro Processing Unit), a DSP (Digital Signal Processor), or the like. The storage device 206b is a nonvolatile memory such as a ROM (Read Only Memory), a flash memory, and a hard disk drive or a volatile memory generally called a RAM (Random Access Memory).

The VCU 206 manages and controls the whole of the work machine 100. The VCU 206 is connected to the BMU 202, the charger 203, and the inverter 205 via signal lines. The VCU 206 obtains the operation data (including the cell voltages, the cell temperatures, and the current value) of the battery pack 210 and the SOC and the SOH thereof from the BMU 202. The VCU 206 controls the charger 203 and the inverter 205 on the basis of the obtained data.

The VCU 206 computes a battery state value on the basis of a minimum value and a maximum value of the cell voltages included in the obtained operation data. The VCU 206 diagnoses the state of the battery pack 210 on the basis of the computed battery state value. That is, the VCU 206 according to the present embodiment has a battery diagnosing function of performing diagnosis as to whether the battery pack 210 is normal, whether an abnormality has occurred in the battery pack 210, or the like. The nonvolatile memory constituting the storage device 206b stores a program for exerting the battery diagnosing function and various threshold values.

Incidentally, the minimum value of the cell voltages refers to a lowest cell voltage among the cell voltages of the plurality of battery cells 212 constituting the battery pack 210. The maximum value of the cell voltages refers to a highest cell voltage among the cell voltages of the plurality of battery cells 212 constituting the battery pack 210. The battery state value is, for example, a minimum cell capacity or the like, as will be described later.

The VCU 206 is connected to an operation sensor 221b, a posture sensor 222, a lock lever position sensor 223b, a solenoid valve 241, a display device 231, and a communicating device 232 via signal lines. The VCU 206 performs two-way communication via a wide area network communication line 281 with a server 280 that is installed in a place remote from a work site where the work machine 100 is performing work.

The server 280 is provided in a management facility of the work machine 100, for example, and is connected to a communicating device 282. The communicating device 232 provided in the work machine 100 and the communicating device 282 provided in the management facility have communication interfaces that enable the two-way communication via the communication line 281. For example, the communicating device 232 mounted in the work machine 100 is a wireless communication device capable of wireless communication with a wireless base station connected to the communication line 281, and has a communication interface including a communication antenna having a band such as a 2.1-GHz band as a reception band.

The display device 231 is a liquid crystal display device, an organic EL display device, or the like. Incidentally, the display device 231 functions as an output device that outputs, in an image, information such as a result of diagnosis of the battery pack 210 by the VCU 206. In addition, the communicating device 232 functions as an output device that outputs the information such as the result of diagnosis of the battery pack 210 by the VCU 206 to the server 280 via the communication line 281.

The server 280 is connected to a display device 283 as an output device that outputs the information obtained from the VCU 206 in an image. As with the display device 231, the display device 283 is a liquid crystal display device, an organic EL display device, or the like.

The operation sensor 221b senses an operation amount of a control lever 221a of a hydraulic actuator 243 and outputs a signal indicating a result of the sensing to the VCU 206. The hydraulic actuator 243 is the boom cylinder 108, the arm cylinder 109, the bucket cylinder 110, the travelling motors 111, and the like. The VCU 206 outputs, to the solenoid valve 241, a control signal corresponding to the operation amount and an operation direction of the control lever 221a. The solenoid valve 241 generates an operation pressure corresponding to the control signal from the VCU 206 and outputs the operation pressure to a control valve 242. The control valve 242 is controlled according to the operation pressure output from the solenoid valve 241. When the control valve 242 is controlled, the flow rate of the hydraulic operating fluid supplied from the hydraulic pump to the hydraulic actuator 243 is controlled, and thereby the operation of the hydraulic actuator 243 is controlled. When the hydraulic actuator 243 operates, the posture of the work device 104 changes, or the lower track structure 106 travels.

The posture sensor 222 senses the posture of the work device 104 and outputs a signal indicating a result of the sensing to the VCU 206. The posture sensor 222 includes, for example, a boom angle sensor that senses the rotational angle of the boom 101 with respect to the upper swing structure 105, an arm angle sensor that senses the rotational angle of the arm 102 with respect to the boom 101, and a bucket angle sensor that senses the rotational angle of the bucket 103 with respect to the arm 102.

The lock lever position sensor 223b senses an operation position of a gate lock lever 223a and outputs a signal indicating a result of the sensing to the VCU 206. The gate lock lever 223a is an operation device operable to be switched to a lock position at which the operation of the control lever 221a is disabled and a lock release position at which the operation of the control lever 221a is enabled.

<Functions of VCU>

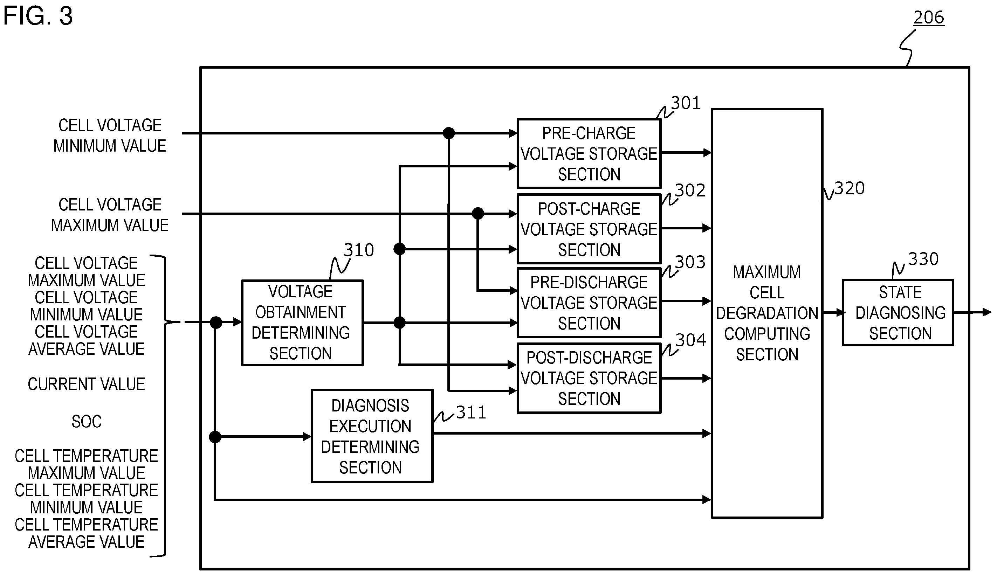

FIG. 3 is a functional block diagram of assistance in explaining the battery diagnosing function of the VCU 206 in FIG. 2. FIG. 3 illustrates functions of the VCU 206 implemented by executing a program stored in the storage device 206b by the processing device 206a.

The VCU 206 includes a pre-charge voltage storage section 301, a post-charge voltage storage section 302, a pre-discharge voltage storage section 303, a post-discharge voltage storage section 304, a voltage obtainment determining section 310, a diagnosis execution determining section 311, a maximum cell degradation computing section 320, and a state diagnosing section 330.

The maximum cell degradation computing section 320 computes a minimum cell capacity as the battery state value that can be used to diagnose the state of the battery pack 210. Incidentally, the minimum cell capacity refers to the cell capacity of a battery cell 212 having a lowest full charge capacity among the plurality of battery cells 212 constituting the battery pack 210. In addition, the battery cell 212 having the lowest full charge capacity among the plurality of battery cells 212 constituting the battery pack 210 will be described also as a minimum capacity cell.

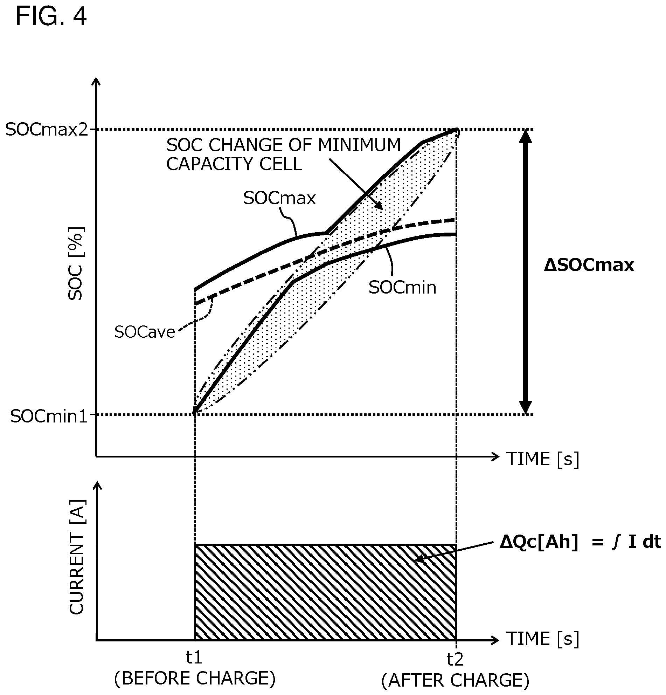

Referring to FIG. 4, description will be made of temporal changes in the SOC of the minimum capacity cell. FIG. 4 is a diagram illustrating an example of temporal changes in the SOC of the minimum capacity cell during a charge. FIG. 4 illustrates also a graph of the current value (hereinafter written as a current graph) together with a graph illustrating temporal changes in the SOC of the minimum capacity cell (hereinafter written as an SOC graph).

As illustrated in FIG. 4, axes of abscissas of the SOC graph and the current graph indicate time [s], where t1 denotes a time point immediately before a start of the charge, that is, before the charge, and t2 denotes a time point immediately after an end of the charge, that is, after the charge. An axis of ordinates of the SOC graph denotes the SOCs [%] of the battery cells 212.

The example illustrated in FIG. 4 represents a case where a battery cell 212 having a lowest SOC among the plurality of battery cells 212 constituting the battery pack 210 at time t1 is the minimum capacity cell, and a battery cell 212 having a highest SOC among the plurality of battery cells 212 constituting the battery pack 210 at time t2 is also the minimum capacity cell.

That is, the example illustrated in FIG. 4 represents a case where the cell voltage of the minimum capacity cell is the minimum value before the charge and is the maximum value after the charge. The SOC of the minimum capacity cell changes, for example, in a range indicated by dot hatching in the SOC graph.

In the SOC graph, a temporal change SOCmax in the maximum value of the SOCs and a temporal change SOCmin in the minimum value of the SOCs are indicated by solid lines, and a temporal change SOCave in an average value of the SOCs is indicated by a broken line. The temporal change SOCmax in the maximum value of the SOCs is obtained by plotting the maximum value of the SOCs of the plurality of battery cells 212 constituting the battery pack 210 at each time. The temporal change SOCmin in the minimum value of the SOCs is obtained by plotting the minimum value of the SOCs of the plurality of battery cells 212 constituting the battery pack 210 at each time. The temporal change SOCave in the average value of the SOCs is obtained by plotting the average value of the SOCs of the plurality of battery cells 212 constituting the battery pack 210 at each time.

Here, if the state of the battery pack 210 is diagnosed on the basis of a difference between the maximum value of the SOCs before the charge (at time t1) and the maximum value of the SOCs after the charge (at time t2) in the example illustrated in FIG. 4, the change between the SOCs before and after the charge is underestimated, and therefore, the battery pack 210 may erroneously be diagnosed as normal. Incidentally, a similar problem occurs also in a case where the state of the battery pack 210 is diagnosed on the basis of a change between the minimum values of the SOCs before and after the charge or a change between the average values of the SOCs before and after the charge.

Accordingly, assuming a worst case as illustrated in FIG. 4, the present embodiment diagnoses the state of the battery pack 210 on the basis of a difference between a minimum value SOCmin1 of the SOCs before the charge (at time t1) and a maximum value SOCmax2 of the SOCs after the charge (at time t2). In the following, description will be made of a method of diagnosing the state of the battery pack 210 according to the present embodiment.

A lowest cell voltage among the cell voltages of the plurality of battery cells 212 constituting the battery pack 210 before the charge (at time t1) is set as a cell voltage minimum value Vmin1. In addition, a highest cell voltage among the cell voltages of the plurality of battery cells 212 constituting the battery pack 210 after the charge (at time t2) is set as a cell voltage maximum value Vmax2. An SOC maximum change amount $\Delta$SOCmax resulting from the charging of the minimum capacity cell in the worst case corresponds to a difference between the minimum value SOCmin1 of the SOCs before the charge and the maximum value SOCmax2 of the SOCs after the charge. A minimum cell capacity Qmin is computed from a charging charge amount $\Delta$Q and the SOC maximum change amount $\Delta$SOCmax.

The SOC maximum change amount $\Delta$SOCmax is computed by the following Equation (1A):

$$\Delta SOCmax = SOCmax2 - SOCmin1 \quad ...(1A)$$

The minimum value SOCmin1 of the SOCs before the charge (at time t1) is obtained from the cell voltage minimum value Vmin1. The maximum value SOCmax2 of the SOCs after the charge (at time t2) is obtained from the cell voltage maximum value Vmax2.

The minimum cell capacity Qmin [Ah] is computed by the following Equation (2A):

$$Qmin = \Delta Qc/(\Delta SOCmax/100) \ldots (2A)$$

Here, $\Delta Qc$ [Ah] is a charging charge amount obtained by integrating the current value I of a charging current input to the battery pack 210 between the state before the charge (at time t1) and the state after the charge (at time t2).

Whether or not an abnormality has occurred in the battery pack 210 can be diagnosed by comparing the thus computed minimum cell capacity Qmin with a predetermined capacity threshold value Qmin0. The capacity threshold value Qmin0 is a threshold value for determining whether or not there is a battery cell 212 whose full charge capacity does not meet a standard (hereinafter written also as an abnormally degraded battery cell). The capacity threshold value Qmin0 is, for example, a value that is approximately 70% of an initial capacity of the battery cell 212, and is stored in the storage device 206b in advance.

The VCU 206 computes the minimum value SOCmin1 of the SOCs on the basis of the minimum value Vmin1 of the cell voltages measured when the charge/discharge state of the battery pack 210 is a state before the charge. In addition, the VCU 206 computes the maximum value SOCmax2 of the SOCs on the basis of the maximum value Vmax2 of the cell voltages measured when the charge/discharge state of the battery pack 210 is a state after the charge. Further, the VCU 206 computes the minimum cell capacity Qmin as the battery state value on the basis of the SOC maximum change amount $\Delta SOCmax$ as a difference between the maximum value and the minimum value of the SOCs and the charging charge amount $\Delta Qc$ from the state before the charge to the state after the charge. The VCU 206 diagnoses whether or not an abnormally degraded battery cell has occurred in the battery pack 210 on the basis of the computed minimum cell capacity Qmin.

Incidentally, while a method of computing the minimum cell capacity Qmin by using data at the time of the charge has been described in the above description, the minimum cell capacity Qmin may be computed by using data at the time of a discharge.

A highest voltage among the voltages of the plurality of battery cells 212 constituting the battery pack 210 before the discharge is set as a cell voltage maximum value Vmax1. In addition, a lowest voltage among the voltages of the plurality of battery cells 212 constituting the battery pack 210 after the discharge is set as a cell voltage minimum value Vmin2. The SOC maximum change amount $\Delta SOCmax$ resulting from the discharging of the minimum capacity cell in a worst case corresponds to a difference between a maximum value SOCmax1 of the SOCs before the discharge and a minimum value SOCmin2 of the SOCs after the discharge. The minimum cell capacity Qmin is computed from a discharge charge amount $\Delta Q$ and the SOC maximum change amount $\Delta SOCmax$.

The SOC maximum change amount $\Delta SOCmax$ is computed by the following Equation (1B):

$$\Delta SOCmax = SOCmax1 - SOCmin2 \ldots (1B)$$

The maximum value SOCmax1 of the SOCs before the discharge is obtained from the cell voltage maximum value Vmax1. The minimum value SOCmin2 of the SOCs after the discharge is obtained from the cell voltage minimum value Vmin2.

The minimum cell capacity Qmin [Ah] is computed by the following Equation (2B):

$$Qmin = \Delta Qd/(\Delta SOCmax/100) \ldots (2B)$$

Here, $\Delta Qd$ [Ah] is a discharge charge amount obtained by integrating the current value I of a discharge current output from the battery pack 210 between the state before the discharge and the state after the discharge.

The VCU 206 computes the maximum value SOCmax1 of the SOCs on the basis of the maximum value Vmax1 of the cell voltages measured when the charge/discharge state of the battery pack 210 is a state before the discharge. In addition, the VCU 206 computes the minimum value SOCmin2 of the SOCs on the basis of the minimum value Vmin2 of the cell voltages measured when the charge/discharge state of the battery pack 210 is a state after the discharge. Further, the VCU 206 computes the minimum cell capacity Qmin as the battery state value on the basis of the SOC maximum change amount $\Delta SOCmax$ as a difference between the maximum value and the minimum value of the SOCs and the discharge charge amount $\Delta Qd$ from the state before the discharge to the state after the discharge. The VCU 206 diagnoses whether or not an abnormally degraded battery cell has occurred in the battery pack 210 on the basis of the computed minimum cell capacity Qmin.

Incidentally, whether the battery pack 210 is being charged, being discharged, or being idle without being charged or discharged can be determined on the basis of the current value I of the current flowing through the battery pack 210. For example, when the current value I is equal to or larger than an idleness determination current lower limit value (threshold value) Ipmin and equal to or smaller than an idleness determination current upper limit value (threshold value) Ipmax, the VCU 206 determines that the battery pack 210 is being idle, that is, that the work machine 100 is being idle.

Incidentally, the current value I is positive during the charging of the battery cell 212 and is negative during the discharging of the battery cell 212.

When the current value I is smaller than the idleness determination current lower limit value Ipmin, the VCU 206 determines that the battery pack 210 is being discharged, that is, that the work machine 100 is performing work. When the current value I is larger than the idleness determination current upper limit value Ipmax, the VCU 206 determines that the battery pack 210 is being charged, that is, that the work machine 100 is being charged.

It is to be noted that a method of determining the charge/discharge state of the battery pack 210, that is, the state of the work machine 100, is not limited to the method using the current value I. The charge/discharge state of the battery pack 210, that is, the state of the work machine 100, may be determined on the basis of an index other than the current value I that flows through the battery cell 212.

The VCU 206 determines whether or not an idleness condition illustrated in the following is satisfied. When the idleness condition is satisfied, the VCU 206 determines that the battery pack 210 is being idle, that is, that the work machine 100 is being idle.

Idleness condition: the- gate lock lever 223a is operated to the lock position, and the rotational speed of the electric motor 204 is 0 [rpm].

The VCU 206 determines whether or not a work condition illustrated in the following is satisfied. When the work condition is satisfied, the VCU 206 determines that the battery pack 210 is being discharged, that is, that the work machine 100 is performing work.

Work condition: the gate lock lever 223a is operated to the lock release position, and the control lever 221a is being operated.

The VCU 206 determines whether or not a charge condition illustrated in the following is satisfied. When the charge condition is satisfied, the VCU 206 determines that the battery pack 210 is being charged, that is, that the work machine 100 is being charged.

Charge condition: a charging cable is connected to the charger 203, and a charging switch (not illustrated) is operated to an on position.

Incidentally, the VCU 206 may determine on the basis of a sensing result of the posture sensor 222 that the work condition is satisfied when the work device 104 is operating.

<Flow of Battery Diagnosis Processing>

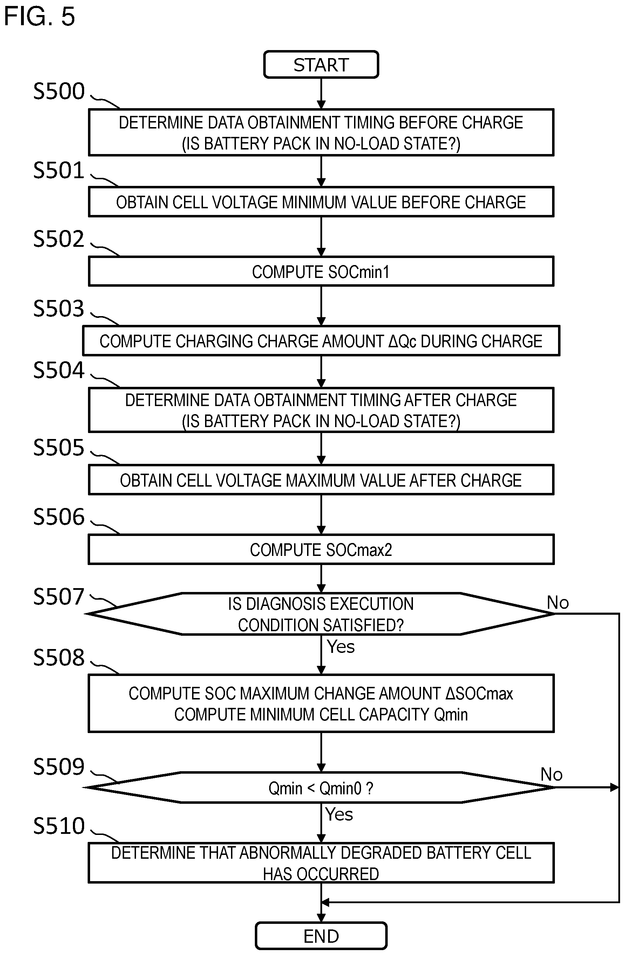

Next, referring to FIG. 3 and FIG. 5, description will be made of an example of a flow of battery diagnosis processing according to the present embodiment. In the following, an example in a charging situation will be illustrated. However, the battery diagnosis processing can be performed similarly also in a discharging situation.

FIG. 5 is a flowchart of assistance in explaining an example of the flow of the battery diagnosis processing performed by the VCU 206. The processing of the flowchart illustrated in FIG. 5 is, for example, started by turning on a start switch (such as an ignition switch) of the work machine 100 and is repeatedly performed in a predetermined control cycle. Thoughnot illustrated in the figure, an abnormality determination flag is set to be off in an initial setting.

In step S500, the voltage obtainment determining section 310 determines a timing of obtaining the cell voltage minimum value Vmin1 before the charge as data to be used in the battery diagnosis processing .(described also as a pre-charge obtainment timing).

The voltage obtainment determining section 310 determines the pre-charge obtainment timing on the basis of a cell temperature, a current value, and a cell voltage obtained from the BMU 202, and sets a pre-charge obtainment flag in an on state. The cell temperature used to determine the timing is, for example, the minimum value or the average value of the cell temperatures. Incidentally, the voltage obtainment determining section 310 may determine the pre-charge obtainment timing with the SOC further taken into consideration.

In this determination processing, the voltage obtainment determining section 310 determines whether or not the state of the battery pack 210 is a no-load state (that is, being idle). Specifically, the voltage obtainment determining section 310 determines that the battery pack 210 is in the no-load state when a predetermined time tp1 has passed in a state in which the absolute value $|I|$ of the current value obtained from the BMU 202 (hereinafter described also as a current absolute value) is equal to or smaller than a no-load current upper limit value (predetermined value) I0 for diagnosis. The voltage obtainment determining section 310 determines that the battery pack 210 is not in the no-load state (that is, that the battery pack 210 is in a load state) when the current absolute value $|I|$ is larger than the no-load current upper limit value I0 for diagnosis or when the predetermined time tp1 has not passed in the state in which the current absolute value $|I|$ is equal to or smaller than the no-load current upper limit value I0 for diagnosis.

The no-load current upper limit value I0 is a threshold value for determining that a load on the battery pack 210 is small, that is, that the battery pack 210 is not being charged or discharged. The no-load current upper limit value I0 is a value of approximately 5 [A], for example. The predetermined time tp1 corresponds to a necessary elapsed time until the cell voltages become so stable that polarization is negligible after the current flowing through the battery pack 210 becomes equal to or smaller than the no-load current upper limit value I0. The necessary elapsed time until the polarization is resolved depends on the cell temperatures. Therefore, for example, the predetermined time tp1 is calculated from a map with respect to the minimum value or the average value of the cell temperatures. This map is defined in advance and is stored in the storage device 206b. Incidentally, a map based on two axes of the cell temperatures and the SOCs may be stored in the storage device 206b.

The voltage obtainment determining section 310 determines a timing determined to be that of the no-load state, as the pre-charge obtainment timing.

When the pre-charge obtainment flag is set in an on state in step S500, the pre-charge voltage storage section 301 in next step S501 obtains and stores the cell voltage minimum value Vmin1 before the charge.

In next step S502, the maximum cell degradation computing section 320 computes the minimum value SOCmin1 of the SOCs before the charge from the cell voltage minimum value Vmin1 before the charge obtained in step S501, on the basis of an SOC-OCV characteristic of the battery cell 212. The OCV (Open Circuit Voltage) is a terminal voltage in an open state, that is, the voltage of the battery cell 212 when no current is applied thereto.

In next step S503, the maximum cell degradation computing section 320 computes the charging charge amount $\Delta Qc$ from a current integrated value during the charge.

Next step S504 is processing similar to step S500. In step S504, the voltage obtainment determining section 310 determines a timing of obtaining the cell voltage maximum value Vmax2 after the charge as data to be used for the battery diagnosis processing (described also as a post-charge obtainment timing).

The voltage obtainment determining section 310 determines the post-charge obtainment timing on the basis of a cell temperature, a current value, and a cell voltage obtained from the BMU 202, and sets a post-charge obtainment flag in an on state. The cell temperature used to determine the timing is, for example, the minimum value or the average value of the cell temperatures. Incidentally, the voltage obtainment determining section 310 may determine the post-charge obtainment timing with the SOC further taken into consideration.

In this determination processing, the voltage obtainment determining section 310 determines whether or not the state of the battery pack 210 is a no-load state (that is, being idle). Specifically, the voltage obtainment determining section 310 determines that the battery pack 210 is in the no-load state when a predetermined time tp2 has passed in a state in which the current absolute value |I| is equal to or smaller than the no-load current upper limit value (predetermined value) I0 for diagnosis. The voltage obtainment determining section 310 determines that the battery pack 210 is not in the no-load state (that is, that the battery pack 210 is in a load state) when the current absolute value |I| is larger than the no-load current upper limit value I0 for diagnosis or when the predetermined time tp2 has not passed in the state in which the current absolute value |I| is equal to or smaller than the no-load current upper limit value I0 for diagnosis.

The no-load current upper limit value I0 is a threshold value for determining that a load on the battery pack 210 is small, that is, that the battery pack 210 is not being charged or discharged. The no-load current upper limit value I0 is a value of approximately 5 [A], for example. The predetermined time tp2 corresponds to a necessary elapsed time until the cell voltages become so stable that polarization is negligible after the current flowing through the battery pack 210 becomes equal to or smaller than the no-load current upper limit value I0. The predetermined time tp2 is calculated from a map with respect to the minimum value or the average value of the cell temperatures. This map is defined in advance and is stored in the storage device 206b. Incidentally, a map based on two axes of the cell temperatures and the SOCs may be stored in the storage device 206b.

The voltage obtainment determining section 310 determines a timing determined to be that of the no-load state, as the post-charge obtainment timing.

Incidentally, the predetermined time tp2 used in the processing of determining the post-charge obtainment timing (step S504) may be computed by using the same map as the map used to compute the predetermined time tp1 used in the processing of determining the pre-charge obtainment timing (step S500), or may be computed by using a different map.

When the post-charge obtainment flag is set in an on state in step S504, the post-charge voltage storage section 302 in next step S505 obtains and stores the cell voltage maximum value Vmax2 after the charge.

In next step S506, the maximum cell degradation computing section 320 computes the maximum value SOCmax2 of the SOCs after the charge from the cell voltage maximum value Vmax2 after the charge obtained in step S505, on the basis of the SOC-OCV characteristic of the battery cell 212.

In next step S507, the diagnosis execution determining section 311 determines whether or not a diagnosis execution condition is satisfied, on the basis of the maximum value, the minimum value, and the average value of the cell voltages, the maximum value, the minimum value, and the average value of the cell temperatures, the current value, and the SOC obtained from the BMU 202. The diagnosis execution condition is defined to prevent an erroneous diagnosis. Details of the diagnosis execution condition will be described later.

When it is determined in step S507 that the diagnosis execution condition is satisfied, the processing proceeds to step S508. When it is determined in step S507 that the diagnosis execution condition is not satisfied, the processing illustrated in the flowchart of FIG. 5 is ended without diagnosing the state of the battery pack 210 on the basis of the battery state value (minimum cell capacity Qmin).

In step S508, the maximum cell degradation computing section 320 computes the SOC maximum change amount ΔSOCmax resulting from the charging of the minimum capacity cell in the worst case by using Equation (1A) on the basis of the minimum value SOCmin1 of the SOCs before the charge computed in step S502 and the maximum value SOCmax2 of the SOCs after the charge computed in step S506.

Further, in step S508, the maximum cell degradation computing section 320 computes the minimum cell capacity Qmin by using Equation (2A) on the basis of the SOC maximum change amount ΔSOCmax and the charging charge amount ΔQc computed in step S503.

In next step S509, the state diagnosing section 330 determines whether or not the minimum cell capacity Qmin computed in step S508 is lower than the capacity threshold value Qmin0. When it is determined in step S509 that the minimum cell capacity Qmin is lower than the capacity threshold value Qmin0, the processing proceeds to step S510. When it is determined in step S509 that the minimum cell capacity Qmin is equal to or higher than the capacity threshold value Qmin0, the processing illustrated in the flowchart of FIG. 5 is ended.

In step S510, the state diagnosing section 330 determines that an abnormally degraded battery cell whose cell capacity is abnormally decreased has occurred in the battery pack 210. In step S510, the state diagnosing section 330 sets, in an on state, the abnormality determination flag indicating that the abnormally degraded battery cell has occurred (that is, an abnormal degradation of the battery pack 210 has occurred). The processing illustrated in the flowchart of FIG. 5 is then ended. Incidentally, though not illustrated in the figure, when a negative determination is made in step S509, the abnormality determination flag is maintained in the initial off state.

An example of the flow of the battery diagnosis processing in the charging situation has been described with reference to FIG. 3 and FIG. 5. However, the flow of the battery diagnosis processing in the discharging situation is similar. In this case, in a pre-discharge obtainment timing determined by the voltage obtainment determining section 310, the pre-discharge voltage storage section 303 obtains and stores the cell voltage maximum value Vmax1 before the discharge. In addition, in a post-discharge obtainment timing determined by the voltage obtainment determining section 310, the post-discharge voltage storage section 304 obtains and stores the cell voltage minimum value Vmin2 after the discharge. The maximum cell degradation computing section 320 computes the minimum cell capacity Qmin on the basis of the cell voltage maximum value Vmax1 before the discharge and the cell voltage minimum value Vmin2 after the discharge.

As described above, when it is determined by the battery diagnosis processing that an abnormality has occurred in the battery pack 210, the abnormality determination flag is set in an on state. When the abnormality determination flag is set in an on state, the VCU 206 outputs a control signal to the display device 231 provided in a cab of the work machine 100 and makes a display screen of the display device 231 display an image indicating that an abnormality has occurred. In addition, when the abnormality determination flag is set in an on state, the VCU 206 outputs a control signal to the communicating device 232 and transmits error information for notifying that an abnormality has occurred to the server 280 via the communicating device 232. This error information includes an identification ID for identifying the work machine 100, a time at which the abnormality flag is set in an on state, and the like.

<Diagnosis Execution Condition>

Next, description will be made of concrete examples of the diagnosis execution condition used in the determination processing (step S507) performed by the diagnosis execution determining section 311.

In general, when the cell temperatures are low, the computation accuracy of the SOCs is poorer than when the cell temperatures are high. Therefore, the diagnosis execution condition preferably includes the following first condition (temperature condition).

First condition: a cell temperature T is equal to or higher than a temperature lower limit value T0.

The temperature lower limit value (threshold value) T0 is approximately 10°C, for example.

In addition, when the cell temperatures within the battery pack 210 vary greatly, variations occur also in the computation accuracy of the SOCs, so that the state of the battery pack 210 may not be able to be diagnosed accurately. Therefore, the diagnosis execution condition preferably includes the following second condition (temperature variation condition).

Second condition: a difference ΔT between the maximum value and the minimum value of the cell temperatures of the plurality of battery cells 212 constituting the battery pack 210 is less than a temperature difference upper limit value ΔT0.

The temperature difference upper limit value (threshold value) ΔT0 is approximately 10°C, for example.

The SOCs of the battery cells 212 depend on the SOC-OCV characteristic. However, there is an SOC range in which a gradient is small and the accuracy of calculating the SOCs from the cell voltages is poor. Therefore, the diagnosis execution condition preferably includes the following third condition (SOC condition).

Third condition: the SOC of the battery pack 210 as a whole before the charge is lower than a first SOC threshold value SOCt1, and the SOC of the battery pack 210 as a whole after the charge is higher than a second SOC threshold value SOCt2.

The first SOC threshold value SOCt1 and the second SOC threshold value SOCt2 are defined to avoid the above-described SOC range.

Incidentally, whether or not the SOC of the battery pack 210 as a whole is within the above-described SOC range may be determined by using the voltage of the battery pack 210 in place of using the SOC of the battery pack 210.

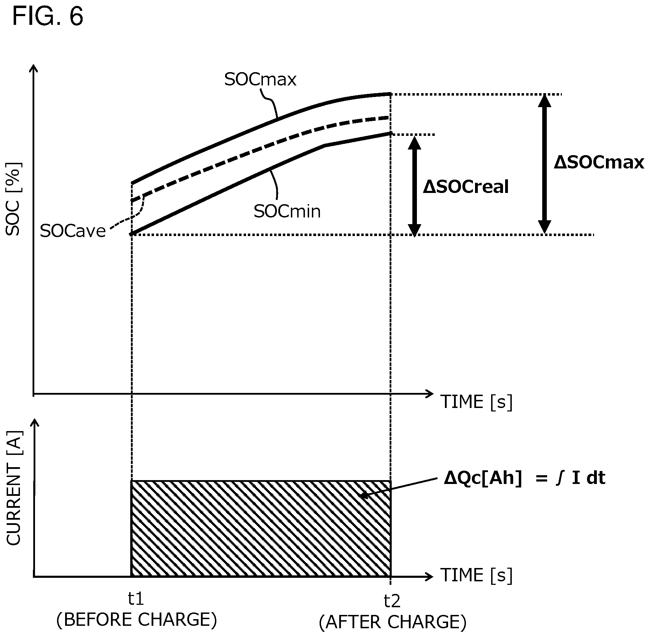

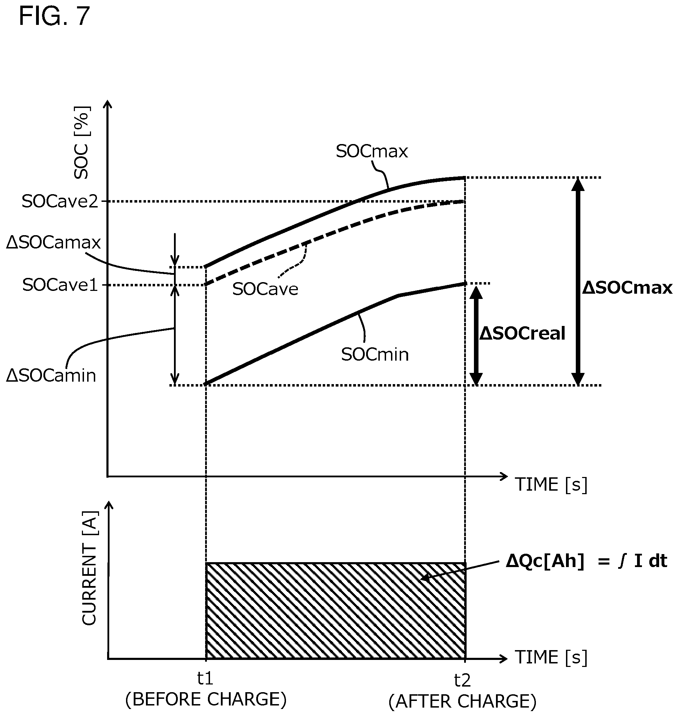

Next, referring to FIG. 6 and FIG. 7, description will be made of an example of a case in which an erroneous diagnosis tends to be made in the battery diagnosing method in the present embodiment. FIG. 6 is a diagram of assistance in explaining the case of a first example in which an erroneous diagnosis tends to be made. As with FIG. 4, FIG. 6 illustrates an SOC graph and a current graph. As illustrated in FIG. 6, unlike the worst case, the first example is a case in which the SOCs of the respective battery cells 212 change in parallel with each other with the passage of time. In the present embodiment, the minimum cell capacity Qmin is computed from the SOC maximum change amount ΔSOCmax and the charging charge amount ΔQc by using Equations (1A) and (2A).

In the case illustrated in FIG. 6, the SOC maximum change amount ΔSOCmax is larger than an SOC maximum change amount ΔSOCreal of an actual abnormally degraded battery cell by the amount of SOC variation due to cell voltage variation within the battery pack 210. As a result, the minimum cell capacity Qmin is calculated to be lower than in actuality, and is thus evaluated as being degraded more than in actuality.

In this case, the larger the value of the SOC maximum change amount ΔSOCreal of the actual abnormally degraded battery cell, the smaller the effect of the SOC variation due to the cell voltage variation described above. Here, in the present embodiment, the VCU 206 sets only the minimum value, the average value, and the maximum value of the cell voltages as targets of computation instead of setting the cell voltages of all of the battery cells 212 as targets of computation. It is therefore difficult to calculate the SOC maximum change amount ΔSOCreal of the actual abnormally degraded battery cell. Accordingly, whether or not to perform the battery diagnosis processing is determined by using a change amount ΔSOCave of the SOC average value as a parameter that replaces the SOC maximum change amount ΔSOCreal of the actual abnormally degraded battery cell. That is, the diagnosis execution condition preferably includes the following fourth condition (SOC variation condition).

Fourth condition: the change amount ΔSOCave of the SOC average value is equal to or larger than a change amount threshold value ΔSOCave0.

The change amount threshold value ΔSOCave0 is approximately 40%, for example.

The change amount ΔSOCave of the SOC average value is computed by the following Equation (3):

$$\Delta SOCave = SOCave2 - SOCave1 \quad ...(3)$$

SOCave1 is the average value of the SOCs before the charge and is obtained from the average value of the cell voltages before the charge. SOCave2 is the average value of the SOCs after the charge and is obtained from the average value of the cell voltages after the charge.

FIG. 7 is a diagram of assistance in explaining the case of a second example in which an erroneous diagnosis tends to be made. As with FIG. 4, FIG. 7 illustrates an SOC graph and a current graph. As illustrated in FIG. 7, the second example is a case in which a self-discharge abnormality has occurred in some of the battery cells 212 within the battery pack 210. In general, the self-discharge abnormality occurs locally within the battery pack 210.

When all of the battery cells 212 of the battery pack 210 are normal, the voltage values of the respective battery cells 212 are distributed substantially uniformly. Therefore, a deviation ΔSOCamin of the SOC minimum value from the average value and a deviation ΔSOCamax of the SOC maximum value from the average value are relatively small. In addition, a difference between the deviation ΔSOCamin and the deviation ΔSOCamax is also relatively small.

On the other hand, when the self-discharge abnormality has occurred in one of the battery cells 212 of the battery pack 210 as in the example illustrated in FIG. 7, the voltage of this battery cell 212 becomes significantly lower than the voltages- of the other battery cells 212. Thus, the cell voltage minimum value and the SOC minimum value SOCmin become significantly lower than at a normal time. Meanwhile, the voltages of the plurality of other battery cells 212 of the battery pack 210 do not become significantly lower. That is, when the self-discharge abnormality has occurred, the cell voltage maximum value and the SOC maximum value SOCmax do not greatly change from those at the normal time. Similarly, the cell voltage average value and the SOC average value SOCave do not greatly change from those at the normal time.

Thus, when the self-discharge abnormality has occurred, the minimum value SOCmin of the SOCs and the cell voltage minimum value tend to decrease. It can therefore be said that the self-discharge abnormality has occurred when the difference between the deviation ΔSOCamin of the SOC minimum value from the average value and the deviation ΔSOCamax of the SOC maximum value from the average value (ΔSOCamin - ΔSOCamax) is larger than a predetermined value.

In this case, the SOC maximum change amount ΔSOCmax is large as compared with the SOC maximum change amount ΔSOCreal of the battery cell 212 in which the self-discharge abnormality has actually occurred, and the minimum cell capacity is calculated to be lower than in actuality, and is thus evaluated as being degraded than in actuality. It is therefore preferable to perform the battery diagnosis processing only when the self-discharge abnormality has not occurred.

Whether or not the self-discharge abnormality has occurred can be determined on the basis of the cell voltages, for example. As compared with an amount of decrease in the cell voltage minimum value due to the self-discharge abnormality, an amount of decrease in the cell voltage average value is small because the amount of decrease in the cell voltage average value is averaged by the number of cells connected in series with each other. Therefore, the deviation of the minimum value of the cell voltages from the average value of the cell voltages is larger than the deviation of the maximum value of the cell voltages from the average value of the cell voltages.

Therefore, the diagnosis execution condition preferably includes the following fifth condition (voltage deviation condition).

Fifth condition: a difference $\Delta Vd$ between a deviation $\Delta Vamin$ of the minimum value of the cell voltages from the average value and a deviation $\Delta Vamax$ of the maximum value of the cell voltages from the average value is smaller than a deviation threshold value $\Delta Vd0$.

The diagnosis execution determining section 311 computes the deviation $\Delta Vamin$ of the minimum value of the cell voltages from the average value by subtracting the minimum value of the cell voltages from the average value of the cell voltages. The diagnosis execution determining section 311 computes the deviation $\Delta Vamax$ of the maximum value of the cell voltages from the average value by subtracting the average value of the cell voltages from the maximum value of the cell voltages. The diagnosis execution determining section 311 computes the difference $\Delta Vd$ between the deviations by subtracting the deviation $\Delta Vamax$ from the deviation $\Delta Vamin$.

The diagnosis execution determining section 311 determines that the self-discharge abnormality has occurred, when the difference $\Delta Vd$ between the deviations is equal to or larger than the deviation threshold value $\Delta Vd0$. The diagnosis execution determining section 311 determines that the self-discharge abnormality has not occurred, when the difference $\Delta Vd$ between the deviations is smaller than the deviation threshold value $\Delta Vd0$.

The diagnosis execution determining section 311 determines that the diagnosis execution condition is satisfied, when all of the first to fifth conditions are satisfied. The diagnosis execution determining section 311 determines that the diagnosis execution condition is not satisfied, when at least one of the first to fifth conditions is not satisfied.

The foregoing embodiment produces the following actions and effects.

A battery diagnosis system 230 includes the VCU (controller) 206 configured to obtain the operation data of the battery pack (power storage device) 210 including the plurality of battery cells (secondary battery cells) 212, compute the battery state value on the basis of the obtained operation data, and diagnose the state of the battery pack 210 on the basis of the computed battery state value, and the output device (the display device 231 and the communicating device 232) that outputs a result of the diagnosis of the battery pack 210 by the VCU 206. The operation data includes the minimum value and the maximum value of the cell voltages of the plurality of battery cells 212 constituting the battery pack 210. The VCU 206 computes the minimum cell capacity $Qmin$ as the battery state value on the basis of the minimum value of the cell voltages measured when the charge/discharge state of the battery pack 210 is in a first state and the maximum value of the cell voltages measured when the charge/discharge state of the battery pack 210 is in a second state.

The VCU 206 can compute the battery state value on the basis of the minimum value and the maximum value of the cell voltages included in the operation data. The VCU 206 does not need to analyze each of the cell voltages of the plurality of battery cells 212 constituting the battery pack 210. An increase in a load of computation processing can therefore be suppressed.

.

The VCU 206 computes the minimum value $SOCmin1$ of the SOCs on the basis of the minimum value $Vmin1$ of the cell voltages measured during a state before a charge (first state). The VCU 206 computes the maximum value $SOCmax2$ of the SOCs on the basis of the maximum value $Vmax2$ of the cell voltages measured during a state after the charge (second state). The VCU 206 computes the minimum cell capacity $Qmin$ on the basis of the SOC maximum change amount $\Delta SOCmax$ as a difference between the maximum value and the minimum value of the SOCs and the charging charge amount $\Delta Qc$ from the state before the charge to the state after the charge. The VCU 206 diagnoses the state of the battery pack 210 on the basis of the minimum cell capacity $Qmin$.

According to this configuration, when there is a battery cell 212 whose cell voltage is lowest before the charge and whose cell voltage is highest after the charge among the plurality of battery cells 212, that is, when there is an abnormally degraded battery cell 212 whose cell voltage changes greatly, this battery cell 212 can be detected. Hence, it is possible to prevent an erroneous determination that the battery pack 210 is normal, when the abnormally degraded battery cell whose voltage change is large exists.

In addition, the VCU 206 computes the maximum value $SOCmax1$ of the SOCs on the basis of the maximum value $Vmax1$ of the cell voltages measured during a state before a discharge (second state). Further, the VCU 206 computes the minimum value $SOCmin2$ of the SOCs on the basis of the minimum value $Vmin2$ of the cell voltages measured during a state after the discharge (first state). The VCU 206 computes the minimum cell capacity $Qmin$ on the basis of the SOC maximum change amount $\Delta SOCmax$ as a difference between the maximum value and the minimum value of the SOCs and the discharge charge amount ΔQd from the state before the discharge to the state after the discharge. The VCU 206 diagnoses the state of the battery pack 210 on the basis of the minimum cell capacity Qmin.

According to this configuration, when there is a battery cell 212 whose cell voltage is highest before the discharge and whose cell voltage is lowest after the discharge among the plurality of battery cells 212, that is, when there is an abnormally degraded battery cell 212 whose cell voltage changes greatly, this battery cell 212 can be detected. Hence, it is possible to prevent an erroneous determination that the battery pack 210 is normal, when the abnormally degraded battery cell whose voltage change is large exists.

As described above, according to the present embodiment, it is possible to provide the battery diagnosis system 230 that can appropriately diagnose the state of the battery pack 210 while suppressing an increase in the load of computation processing on the VCU 206.

Incidentally, the maximum value and the minimum value of the cell voltages used to compute the battery state value are values measured when a predetermined time has passed in a state in which the current value of the current flowing through the battery cells 212 is equal to or smaller than a predetermined value. The battery cells 212 cause polarization when a current is fed thereto. The polarization is a voltage shift from an open circuit voltage due to an electrochemical reaction. Therefore, when the polarization occurs, and thus the cell voltages are unstable, the accuracy of the battery diagnosis may be decreased. The present embodiment measures the maximum value and the minimum value of the cell voltages when a predetermined time has passed in a state in which the current value of the current flowing through the battery cells 212 is equal to or smaller than a predetermined value. It is therefore possible to prevent an erroneous diagnosis resulting from an effect of the polarization.

[First Modification of First Embodiment]

The foregoing first embodiment makes a diagnosis that an abnormally degraded battery cell has occurred in the battery pack 210 when the minimum cell capacity Qmin is lower than the capacity threshold value Qmin0. However, the battery diagnosing method is not limited to this. For example, the VCU 206 may diagnose the state of the battery pack 210 on the basis of the minimum cell capacity and an average cell capacity. In the following, a battery diagnosing method based on the minimum cell capacity and the average cell capacity will be described in detail.

The state diagnosing section 330 determines that an abnormally degraded battery cell has occurred in the battery pack 210 when a capacity ratio Rq as a ratio between the minimum cell capacity and the average cell capacity is lower than a capacity ratio threshold value Rq0.

The maximum cell degradation computing section 320 computes the capacity ratio Rq by the following Equation (4):

$$Rq = Qmin/Qave \quad ...(4)$$

Qave [Ah] is the average cell capacity and is computed by the following Equation (5):

$$Qave = \Delta Qc,d/(\Delta SOCave/100) \quad ...(5)$$

ΔSOCave is an amount of change in the average value of the SOCs and is computed by the above Equation (3), for example. ΔQc,d [Ah] is a charging charge amount or a discharge charge amount.

The capacity ratio Rq represents a degree of deviation from the average cell capacity used for battery control (SOC usage range or the like) by an ordinary battery system. There is a case where no abnormal degradation has occurred when the capacity ratio Rq is high even when the minimum cell capacity Qmin is lower than the capacity threshold value Qmin0. Assuming such a case, the state diagnosing section 330 according to the present modification determines that an abnormal degradation has occurred when the capacity ratio Rq is lower than the capacity ratio threshold value Rq0. The state diagnosing section 330 determines that no abnormal degradation has occurred when the capacity ratio Rq is equal to or higher than the capacity ratio threshold value Rq0.

Incidentally, the capacity ratio threshold value Rq0 is defined on the basis of a value at which there is a risk of the occurrence of an abnormality (for example, a cell voltage abnormality) in the battery system 200 due to variation in cell capacity within the battery pack 210. The capacity ratio threshold value Rq0 is approximately 0.9, for example, and is stored in the storage device 206b in advance.

According to the present modification, it is possible to diagnose the state of the battery pack 210 more appropriately on the basis of the minimum cell capacity and the average cell capacity.

[Second Modification of First Embodiment]

The foregoing first embodiment makes a diagnosis that an abnormally degraded battery cell has occurred in the battery pack 210 when the minimum cell capacity Qmin is lower than the capacity threshold value Qmin0. However, the battery diagnosing method is not limited to this. For example, the VCU 206 may diagnose the state of the battery pack 210 on the basis of a minimum cell capacity degradation rate SOHQmin.

The maximum cell degradation computing section 320 computes the minimum cell capacity degradation rate SOHQmin [%] by the following Equation (6):

$$\text{SOHQmin} = \text{Qmin/Qi} \quad ...(6)$$

Qmin [Ah] is the minimum cell capacity. Qi [Ah] is an initial capacity of the battery cell 212. The initial capacity Qi of the battery cell 212 is stored in the storage device 206b in advance.

The state diagnosing section 330 according to the present modification determines that an abnormal degradation has occurred, when the minimum capacity degradation rate SOHQmin is lower than a threshold value SOHQmin0. The state diagnosing section 330 determines that no abnormal degradation has occurred, when the minimum capacity degradation rate SOHQmin is equal to or higher than the threshold value SOHQmin0. Incidentally, the threshold value SOHQmin0 is approximately 70 [%], for example, and is stored in the storage device 206b in advance.

The present modification can provide effects similar to the effects described in the first embodiment.

[Second Embodiment]

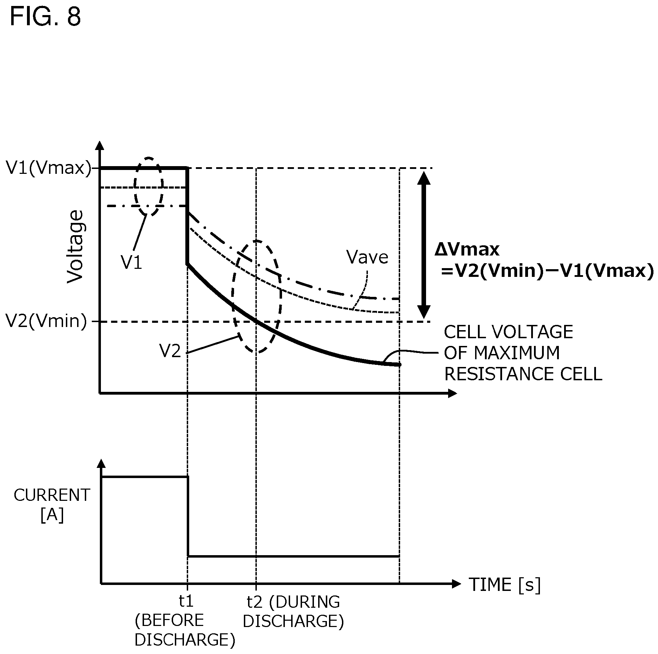

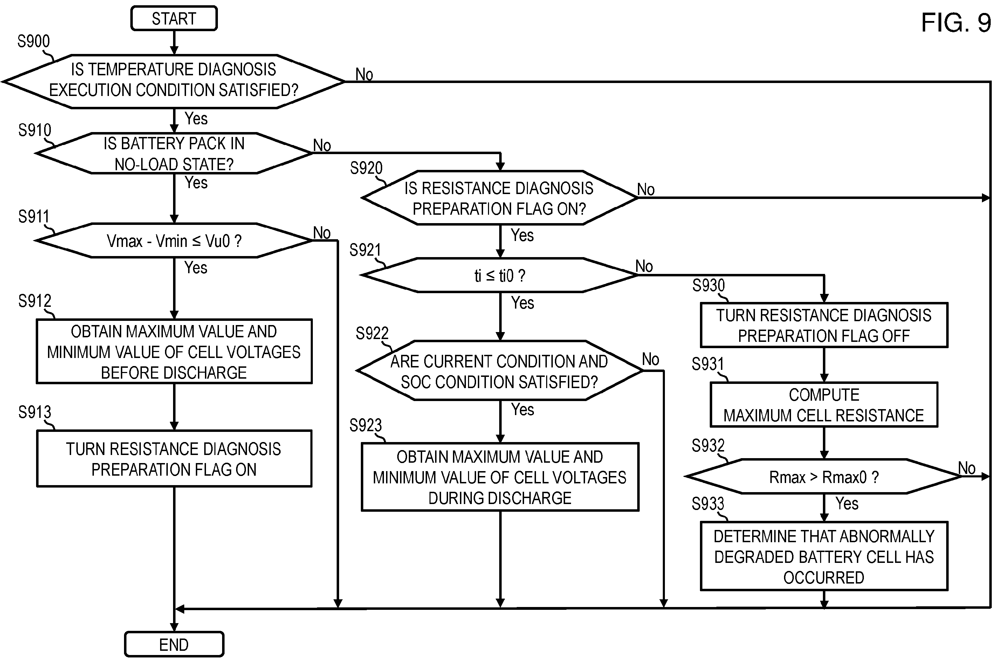

Referring mainly to FIG. 8 and FIG. 9, description will be made of a battery diagnosis system 230 according to a second embodiment of the present invention. Incidentally, configurations identical or corresponding to the configurations described in the first embodiment are denoted by the same reference numerals, and.differences will be mainly described.

The VCU 206 of the battery diagnosis system 230 according to the first embodiment is configured to diagnose the state of the battery pack 210 on the basis of the minimum cell capacity Qmin as a battery state value. On the other hand, the VCU 206 of the battery diagnosis system 230 according to the second embodiment is configured to diagnose the state of the battery pack 210 on the basis of a maximum cell resistance Rmax as a battery state value.

Incidentally, in the following, a battery cell 212 having a highest cell resistance value among the plurality of battery cells 212 constituting the battery pack 210 will be described also as a maximum resistance cell. The maximum cell resistance Rmax refers to the cell resistance value of the maximum resistance cell.

FIG. 8 is a diagram illustrating an example of temporal changes in cell voltage during a discharge. The example illustrated in FIG. 8 assumes, as a worst case, a case in which the cell voltage of the maximum resistance cell changes from a maximum value to a minimum value of the cell voltages in the battery pack 210 in a period before and after the output of the discharge current.

The maximum cell degradation computing section 320 computes the maximum cell resistance Rmax of the battery pack 210, and determines whether or not an abnormally degraded battery cell whose cell resistance value is increased abnormally has occurred in the battery pack 210 on the basis of a result of the computation. In the following, this determining method will be described in detail.

The maximum cell degradation computing section 320 computes the maximum cell resistance Rmax on the basis of a voltage maximum change amount ΔVmax in the period before and after the output of the discharge current from the battery pack 210 and a current difference ΔI in the period before and after the output of the discharge current from the battery pack 210. The maximum cell resistance Rmax is computed by the following Equation (7):

$$\text{Rmax} = \Delta\text{Vmax}/\Delta\text{I} \quad ...(7)$$

The voltage maximum change amount ΔVmax in the period before and after the output of the discharge current from the battery pack 210 is computed by the following Equation (8):

$$\Delta\text{Vmax} = \text{V2(Vmin)} - \text{V1(Vmax)} \quad ...(8)$$

Here, the cell voltage maximum value V1(Vmax) is a maximum value of cell voltages V1 before the output of the discharge current from the battery pack 210, and the cell voltage minimum value V2(Vmin) is a minimum value of cell voltages V2 after the output of the discharge current from the battery pack 210 (during the discharge).

Whether or not an abnormality has occurred in the battery pack 210 can be determined by comparing the thus computed maximum cell resistance Rmax with a predetermined resistance threshold value Rmax0. The resistance threshold value Rmax0 is, for example, a value of approximately 200% of an initial value of the cell resistance value of the battery cell 212 (hereinafter described also as an initial resistance). The resistance threshold value Rmax0 is stored in the storage device 206b in advance.

The VCU 206 computes a voltage maximum change amount $\Delta$Vmax as a difference between the maximum value V1(Vmax) of the cell voltages measured when the charge/discharge state of the battery pack 210 is a state before the discharge (second state) and the minimum value V2(Vmin) of the cell voltages measured when the charge/discharge state of the battery pack 210 is a state during the discharge (first state). The VCU 206 computes the current difference $\Delta$I between the state before the discharge and the state during the discharge. The VCU 206 computes the maximum cell resistance Rmax as a battery state value on the basis of the computed voltage maximum change amount $\Delta$Vmax and the computed current difference $\Delta$I. The VCU 206 diagnoses whether or not an abnormally degraded battery cell has occurred in the battery pack 210, on the basis of the computed maximum cell resistance Rmax.

Incidentally, while a method of computing the maximum cell resistance Rmax by using data at the time of the discharge has been described in the above description, the maximum cell resistance Rmax may be computed by using data at the time of a charge.

In this case, the VCU 206 computes the voltage maximum change amount $\Delta$Vmax as a difference between a minimum value V1(Vmin) of the cell voltages measured when the charge/discharge state of the battery pack 210 is a state before the charge (first state) and a maximum value V2(Vmax) of the cell voltages measured when the charge/discharge state of the battery pack 210 is a state during the charge (second state). In addition, the VCU 206 computes the current difference $\Delta$I between the state before the charge and the state during the charge. The VCU 206 computes the maximum cell resistance Rmax as a battery state value on the basis of the computed voltage maximum change amount $\Delta$Vmax and the computed current difference $\Delta$I. The VCU 206 diagnoses whether or not anabnormally degraded battery cell has occurred in the battery pack 210, on the basis of the computed maximum cell resistance Rmax.

Next, referring to FIG. 3 and FIG. 9, description will be made of an example of a flow of battery diagnosis processing according to the present embodiment. In the following, an example in a discharging situation will be illustrated. However, the battery diagnosis processing can be performed similarly also in a charging situation.

FIG. 9 is a flowchart of assistance in explaining an example of the flow of the battery diagnosis processing performed by the VCU 206. The processing of the flowchart illustrated in FIG. 9 is, for example, started by turning on the start switch (such as the ignition switch) of the work machine 100 and is repeatedly performed in a predetermined control cycle. Though not illustrated in the figure, a resistance diagnosis preparation flag and an abnormality determination flag are each set to be off in an initial setting.

In general, when the cell temperatures are low, the computation accuracy of the maximum cell resistance is poorer than when the cell temperatures are high. In addition, when the cell temperatures within the battery pack 210 vary greatly, variations occur also in the computation accuracy of the maximum cell resistance, so that the state of the battery pack 210 may not be able to be diagnosed accurately. Therefore, the diagnosis execution determining section 311 diagnoses whether or not an abnormally degraded battery cell whose cell resistance value exceeds a reference value has occurred, only when the cell temperatures satisfy a temperature diagnosis execution condition as a diagnosis execution condition.

As illustrated in FIG. 9, in step S900, the diagnosis execution determining section 311 determines whether or not the temperature diagnosis execution condition is satisfied, on the basis of the cell temperatures. The temperature diagnosis execution condition is satisfied when both of the first condition and the second condition described in the first embodiment are satisfied. The temperature diagnosis execution condition is not satisfied when at least one of the first condition and the second condition is not satisfied.

When the temperature diagnosis execution condition is satisfied in step S900, the diagnosis execution determining section 311 determines that a battery diagnosis based on the maximum cell resistance can be performed. The processing then proceeds to step S910. When the temperature diagnosis condition is not satisfied in step S900, the diagnosis execution determining section 311 determines that the battery diagnosis based on the maximum cell resistance cannot be performed. The processing illustrated in the flowchart of FIG. 9 is then ended.

In step S910, the voltage obtainment determining section 310 determines whether or not the state of the battery pack 210 is a no-load state. The processing of step S910 is processing similar to steps S500 and S504 in FIG. 5. The voltage obtainment determining section 310 determines a pre-discharge obtainment timing on the basis of a cell temperature, a current value, and a cell voltage obtained from the BMU 202, and sets an obtainment flag in an on state. The cell temperature used to determine the timing is, for example, the minimum value or the average value of the cell temperatures.

Specifically, the voltage obtainment determining section 310 determines that the battery pack 210 is in the no-load state, when a predetermined time tp3 has passed in a state in which the current absolute value |I| is equal to or smaller than the no-load current upper limit value (predetermined value) I0 for diagnosis. The voltage obtainment determining section 310 determines that the battery pack 210 is not in the no-load state (that is, that the battery pack 210 is in a load state), when the current absolute value |I| is larger than the no-load current upper limit value I0 for diagnosis or when the predetermined time tp3 has not passed in the state in which the current absolute value |I| is equal to or smaller than the no-load current upper limit value I0 for diagnosis.

The no-load current upper limit value I0 is a threshold value for determining that a load on the battery pack 210 is small, that is, that the battery pack 210 is not being charged or discharged. The no-load current upper limit value I0 is a value of approximately 5 [A], for example. The predetermined time tp3 corresponds to a necessary elapsed time until the cell voltages become so stable that polarization is negligible after the current flowing through the battery pack 210 becomes equal to or smaller than the no-load current upper limit value I0. The predetermined time tp3 is calculated from a map with respect to the minimum value or the average value of the cell temperatures. This map is defined in advance and is stored in the storage device 206b. Incidentally, a map based on two axes of the cell temperatures and the SOCs may be stored in the storage device 206b. In addition, the predetermined time tp3 used in the processing of determining the pre-discharge obtainment timing (step S910) may be computed by using the same map as the map used to compute the predetermined times tp1 and tp2 described in the first embodiment, or may be computed by using a different map.

When it is determined in step S910 that the state of the battery pack 210 is the no-load state, the processing proceeds to step S911. When it is determined in step S910 that the state of the battery pack 210 is not the no-load state, the processing proceeds to step S920.

When the cell voltages within the battery pack 210 vary greatly, the maximum cell resistance is calculated to be higher than an actual resistance value, and may thus be evaluated as being degraded more than in actuality. Therefore, the diagnosis execution determining section 311 diagnoses the state of the battery pack 210 on the basis of the battery state value only when the cell voltages satisfy a voltage variation condition as a diagnosis execution condition.

Voltage variation within the battery pack 210 can be expressed by a voltage difference $\Delta V$ obtained by subtracting a cell voltage minimum value Vmin from a cell voltage maximum value Vmax ($\Delta V$ = Vmax - Vmin). The voltage variation condition is satisfied when the voltage difference $\Delta V$ is equal to or smaller than a predetermined voltage difference upper limit value (threshold value) Vu0 for diagnosis. The voltage variation condition is not satisfied when the voltage difference $\Delta V$ is larger than the voltage difference upper limit value Vu0. The voltage difference upper limit value Vu0 is set at a value at which it is not determined that, there is an abnormality in a state without degradation variation. The voltage difference upper limit value Vu0 is set at 20 mV, for example.

In step S911, the diagnosis execution determining section 311 determines whether or not the voltage variation condition as a diagnosis execution condition is satisfied. When the voltage variation condition is satisfied in step S911, the diagnosis execution determining section 311 determines that a battery diagnosis based on the maximum cell resistance can be performed. The processing then proceeds to step S912. When the voltage variation condition is not satisfied in step S911, the diagnosis execution determining section 311 determines that the battery diagnosis based on the maximum cell resistance cannot be performed. The processing illustrated in the flowchart of FIG. 9 is then ended.

In step S912, the pre-discharge voltage storage section 303 obtains and stores the cell voltage minimum value Vmin at that time as the cell voltage minimum value V1(Vmin) before the discharge, and obtains and stores the cell voltage maximum value Vmax at that time as the cell voltage maximum value V1(Vmax) before the discharge.

In next step S913, the maximum cell degradation computing section 320 sets the resistance diagnosis preparation flag in an on state. The processing illustrated in the flowchart of FIG. 9 is then ended.

When work is started by the work machine 100, or charging is started, the current absolute value |I| becomes larger than the no-load current upper limit value I0 for diagnosis. In this case, it is determined in step S910 that the battery pack 210 is in a load state. The processing then proceeds to step S920.

In step S920, the voltage obtainment determining section 310 determines whether or not the resistance diagnosis preparation flag is set in an on state. When it is determined in step S920 that the resistance diagnosis preparation flag is set in an on state, the voltage obtainment determining section 310 counts an elapsed time from a determination of the load state (hereinafter described also as a load elapsed time ti). When it is determined in step S920 that the resistance diagnosis preparation flag is set in an on state, the processing proceeds to step S921. When it is determined in step S920 that the resistance diagnosis preparation flag is set in an off state, the processing illustrated in the flowchart of FIG. 9 is ended.

In step S921, the diagnosis execution determining section 311 determines whether or not the load elapsed time ti is equal to or less than a diagnosis required time ti0. When it is determined in step S921 that the load elapsed time ti is equal to or less than the diagnosis required time ti0, the processing proceeds to step S922. When it is determined in step S921 that the load elapsed time ti is more than the diagnosis required time ti0, the processing proceeds to step 930.

In step S922, the diagnosis execution determining section 311 determines whether or not a current condition and an SOC condition as a diagnosis execution condition are satisfied. The current condition is satisfied when the absolute value |I| of the current flowing through the plurality of battery cells 212 constituting the battery pack 210 is equal to or larger than a current lower limit value Imin0 for diagnosis and equal to or smaller than a current upper limit value Imax0 for diagnosis, as illustrated in the following Equation (9):

$$Imin0 \leq |I| \leq Imax0 \quad ...(9)$$

The current lower limit value Imin0 and the current upper limit value Imax are threshold values determined in advance and are stored in the storage device 206b.

A reason for providing the current condition as such a diagnosis execution condition is that, when the current is not equal to or larger than a certain value, the voltage maximum change amount ΔVmax is small, and there is a risk of the occurrence of an error due to an effect of a voltage sensor error. The current lower limit value Imin0 for diagnosis is set at 50 [A], for example, in consideration of sensor accuracy. In addition, the presence or absence of an abnormality is evaluated by comparison of the maximum cell resistance to be calculated with the initial resistance. Therefore, the current upper limit value Imax0 for diagnosis is preferably set according to an evaluation condition of the initial resistance. The current upper limit value Imax0 for diagnosis is set at 90 [A], for example.

The SOC condition is satisfied when the SOC of the battery pack 210 as a whole is equal to or higher than an SOC lower limit value SOCmin0 for diagnosis and equal to or lower than an SOC upper limit value SOCmax0 for diagnosis, as illustrated in the following Equation (10):

$$SOCmin0 \leq SOC \leq SOCmax0 \quad ...(10)$$

The SOC lower limit value SOCmin0 and the SOC upper limit value SOCmax0 are threshold values determined in advance and are stored in the storage device 206b.

A reason for providing the SOC condition as such a diagnosis execution condition is that there is a battery in which the resistance values of the battery cells change sharply when the SOC is on a low SOC side (for example, when the SOC is equal to or lower than 20%) and when the SOC is on a high SOC side (for example, when the SOC is equal to or higher than 80%), and an error tends to occur in the SOC ranges.

Incidentally, the SOC ranges in which an error tends to occur differ between a charge time and a discharge time. Therefore, the two threshold values (the SOC lower limit value and the SOC upper limit value) are preferably set at values that differ between the charge time and the discharge time.

When both of the current condition and the SOC condition are satisfied in step S922, the diagnosis execution determining section 311 determines that a battery diagnosis based on the maximum cell resistance can be performed. The processing then proceeds to step S923. When at least one of the current condition and the SOC condition is not satisfied in step S922, the diagnosis execution determining section 311 determines that the battery diagnosis based on the maximum cell resistance cannot be performed. The processing illustrated in the flowchart of FIG. 9 is then ended.

In step S923, the post-discharge voltage storage section 304 obtains and stores the cell voltage minimum value Vmin at that time as the cell voltage minimum value V2(Vmin) during the discharge, and obtains and stores the cell voltage maximum value Vmax at that time as the cell voltage maximum value V2(Vmax) during the discharge. Incidentally, "during the discharge" refers to a stage after the output of the discharge current and before an end of the output of the discharge current. When the voltage obtaining processing of step S923 is completed, the processing illustrated in the flowchart of FIG. 9 is ended.

When the work machine 100 continues to perform work, and the load elapsed time ti exceeds the diagnosis required time ti0, or when the charge continues to be performed, and the load elapsed time ti exceeds the diagnosis required time ti0, a negative determination is made in step S921. The processing then proceeds to step 930.

In S930, the maximum cell degradation computing section 320 sets the resistance diagnosis preparation flag in an off state. That is, the resistance diagnosis preparation flag is returned to an initial state.

In next step S931, the maximum cell degradation computing section 320 computes the maximum cell resistance Rmax from the cell voltage maximum value V1(Vmax) before the discharge and the cell voltage minimum value V2(Vmin) during the discharge by using Equations (7) and (8).

In next step S932, the state diagnosing section 330 determines whether or not the maximum cell resistance Rmax computed in step S931 is higher than the resistance threshold value Rmax0. When it is determined in step S932 that the maximum cell resistance Rmax is higher than the resistance threshold value Rmax0, the processing proceeds to step S933. When it is determined in step S932 that the maximum cell resistance Rmax is equal to or lower than the resistance threshold value Rmax0, the processing illustrated in the flowchart of FIG. 9 is ended.

In step S933, the state diagnosing section 330 determines that an abnormally degraded battery cell whose cell resistance value is increased abnormally has occurred in the battery pack 210. In step S933, the state diagnosing section 330 sets, in an on state, the abnormality determination flag indicating that the abnormally degraded battery cell has occurred (that is, that an abnormal degradation of the battery pack 210 has occurred). The processing illustrated in the flowchart of FIG. 9 is then ended. Incidentally, though not illustrated in the figure, when a negative determination is made in step S932, the abnormality determination flag is maintained in an initial off state.

An example of the flow of the battery diagnosis processing in the discharging situation has been described with reference to FIG. 3 and FIG. 9. However, the flow of the battery diagnosis processing in the charging situation is also similar. In this case, in a pre-charge obtainment timing determined by the voltage obtainment determining section 310, the pre-charge voltage storage section 301 obtains and stores the cell voltage minimum value V1(Vmin) before the charge. In addition, in a post-charge obtainment timing determined by the voltage obtainment determining section 310, the post-charge voltage storage section 302 obtains and stores the cell voltage maximum value V2(Vmax) during the charge (after the input of the charging current). The maximum cell degradation computing section 320 computes the maximum cell resistance Rmax on the basis of the cell voltage minimum value V1(Vmin) before the charge and the cell voltage maximum value V2(Vmax) during the charge (after the input of the charging current).

As described above, when it is determined by the battery diagnosis processing that an abnormality has occurred in the battery pack 210, the abnormality determination flag is set in an on state. When the abnormality determination flag is set in an on state, the VCU 206 outputs a control signal to the display device 231 provided in the cab of the work machine 100 and makes the display screen of the display device 231 display an image indicating that an abnormality has occurred. In addition, when the abnormality determination flag is set in an on state, the VCU 206 outputs a control signal to the communicating device 232, and transmits error information for notifying that an abnormality has occurred to the server 280 via the communicating device 232. This error information includes the identification ID for identifying the work machine 100, a time at which the abnormality flag is set in an on state, and the like.

The present second embodiment as described above can provide actions and effects similar to those of the first embodiment.

[First Modification of Second Embodiment]

The foregoing second embodiment makes a diagnosis that an abnormally degraded battery cell has occurred in the battery pack 210, when the maximum cell resistance Rmax is higher than the resistance threshold value Rmax0. However, the battery diagnosing method is not limited to this. For example, the VCU 206 may diagnose the state of the battery pack 210 on the basis of the maximum cell resistance and an average cell resistance. In the following, a battery diagnosing method based on the maximum cell resistance and the average cell resistance will be described in detail.

The VCU 206 determines that an abnormally degraded battery cell has occurred in the battery pack 210, when a resistance ratio Rr as a ratio between the maximum cell resistance and the average cell resistance is higher than a resistance ratio threshold value Rr0.

The resistance ratio Rr is computed by the following Equation (11):

$$Rr = Rmax/Rave ...(11)$$

Rave is the average cell resistance (average value of cell resistance values) and is computed by the following Equation (12):

$$Rave = \Delta Vave/\Delta I ...(12)$$

ΔVave is an amount of change in the average value of the cell voltages and is computed by the following Equation (13):

$$\Delta Vave = V2(Vave) - V1(Vave) ...(13)$$

V1(Vave) is the average value of the cell voltages before the discharge. V2(Vave) is the average value of the cell voltages during the discharge. The average value V1(Vave) of the cell voltages before the discharge is obtained by the pre-discharge voltage storage section 303 in the same timing as the minimum value V1(Vmin) and the maximum value V1(Vmax) of the cell voltages in step S912. The average value V2(Vave) of the cell voltages during the discharge is obtained by the post-discharge voltage storage section 304 in the same timing as the minimum value V2(Vmin) and the maximum value V2(Vmax) of the cell voltages in step S923.

The resistance ratio Rr represents a degree of deviation from the average cell resistance used for battery control (allowable maximum discharge current value or the like) by an ordinary battery system. There is a case where no abnormal degradation has occurred when the resistance ratio Rr is low even when the maximum cell resistance Rmax is higher than the resistance threshold value Rmax0. Assuming such a case, the state diagnosing section 330 according to the present modification determines that an abnormal degradation has occurred, when the resistance ratio Rr is higher than the resistance ratio threshold value Rr0. The state diagnosing section 330 determines that no abnormal degradation has occurred, when the resistance ratio Rr is equal to or lower than the resistance ratio threshold value Rr0.

Incidentally, the resistance ratio threshold value Rr0 is defined on the basis of a value at which there is a risk of the occurrence of an abnormality (for example, a cell voltage abnormality) in the battery system 200 due to variation in cell resistance values within the battery pack 210. The resistance ratio threshold value Rr0 is approximately 1.2, for example, and is stored in the storage device 206b in advance.

According to the present modification, it is possible to diagnose the state of the battery pack 210 more appropriately on the basis of the maximum cell resistance and the average cell resistance.

[Second Modification of Second Embodiment]

The foregoing second embodiment makes a diagnosis that an abnormally degraded battery cell has occurred in the battery pack 210, when the maximum cell resistance Rmax is higher than the resistance threshold value Rmax0. However, the battery diagnosing method is not limited to this. For example, the VCU 206 may diagnose the state of the battery pack 210 on the basis of a maximum cell resistance degradation rate SOHRmax.

The maximum cell degradation computing section 320 computes the maximum cell resistance degradation rate SOHRmax [%] by the following Equation (14):

$$\text{SOHRmax} = \text{Rmax}/\text{Ri} \ \ ...(14)$$

Rmax [mΩ] is the maximum cell resistance. Ri [mΩ] is the initial resistance of the battery cell 212. The initial resistance Ri of the battery cell 212 is stored in the storage device 206b in advance.

The state diagnosing section 330 according to the present modification determines that an abnormal degradation has occurred, when the maximum resistance degradation rate SOHRmax is equal to or higher than a threshold value SOHRmax0. The state diagnosing section 330 determines that no abnormal degradation has occurred, when the maximum resistance degradation rate SOHRmax is lower than the threshold value SOHRmax0. Incidentally, the threshold value SOHRmax0 is approximately 200 [%], for example, and is stored in the storage device 206b in advance.

The present modification can provide effects similar to the effects described in the second embodiment.

[Third Embodiment]

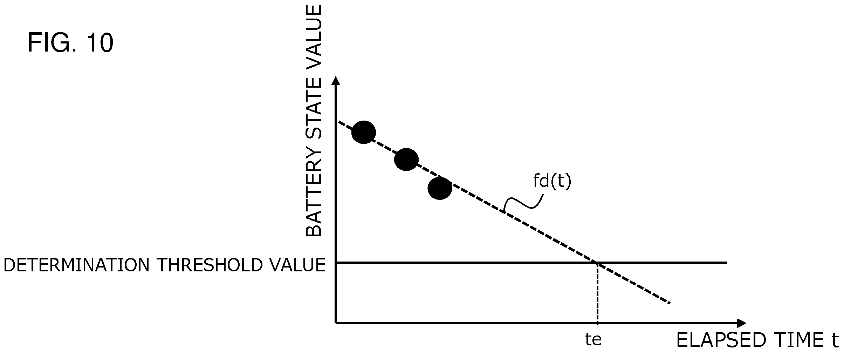

Referring to FIG. 2 and FIG. 10, description will be made of a battery diagnosis system 230 according to a third embodiment. of the present invention. Incidentally, configurations identical or corresponding to the configurations described in the first embodiment and the second embodiment are denoted by the same reference numerals, and differences will be mainly described.

The battery diagnosis system 230 according to the third embodiment includes a controller (for example, the VCU 206) provided in the work machine 100 and the server 280 that communicates with the VCU 206. The VCU 206 transmits time series data of a battery state value computed in battery diagnosis processing to the server 280 via the communicating device 232. The server 280 calculates an approximate equation of the battery state value with time as a variable by analyzing the time series data of the battery state value received from the VCU 206. Incidentally, the battery state value is the minimum cell capacity Qmin, the maximum cell resistance Rmax, the capacity ratio Rq, the minimum capacity degradation rate SOHQmin, the resistance ratio Rr, or the maximum resistance degradation rate SOHRmax described above, or the like. The server 280 predicts an abnormality occurrence timing of the battery pack 210 by using the calculated approximate equation of the battery state value.

FIG. 10 is a diagram illustrating an example of actually measured values and the approximate equation of the battery state value. FIG. 10 illustrates an example in which the battery state value is the minimum cell capacity Qmin. The server 280 analyzes the time series data of the battery state value (actually measured values) indicated by black circles in the figure and generates, for example, an approximate equation fd(t) of elapsed time t in the following Equation (15):

$$\text{fd(t)} = \Delta\text{D} \times \text{t} + \text{a} \ \ ...(15)$$

ΔD is a first-order coefficient. "a" is a constant term.

Incidentally, while an example has been illustrated in which the approximate equation fd(t) described above is a linear equation, the approximate equation fd(t) may be a polynomial of a second order or higher, an exponential function equation, or the like.

The server 280 predicts an abnormality occurrence timing te by using the approximate equation fd(t) of temporal changes in the battery state value. The predicted abnormality occurrence timing te is a timing in which the battery state value reaches a determination threshold value. Incidentally, for example, the determination threshold value is the capacity threshold value Qmin0 when the battery state value is the minimum cell capacity Qmin, and the determination threshold value is the resistance threshold value Rmax0 when the battery state value is the maximum cell resistance Rmax.

When an operation in a present situation is continued in the work machine 100, the server 280 gives a warning before an abnormality occurs. Specifically, the server 280 computes a period from the predicted abnormality occurrence timing te to a present time, that is, a period ta until the determination threshold value is reached. The server 280 determines whether or not the period ta is less than a period threshold value ta0. When the period ta is less than the period threshold value ta0, the server 280 determines that the occurrence of an abnormality in the battery pack 210 of the work machine 100 is approaching.

In this case, the server 280 displays a warning image indicating the determination result on the display screen of the display device 283. In addition, the server 280 may transmit warning information indicating the determination result to the work machine 100 via the communicating device 282. Receiving the warning information, the VCU 206 of the work machine 100 displays a warning image indicating that the occurrence of an abnormality in the battery pack 210 is approaching on the display screen of the display device 231.

Thus, in the present third embodiment, the server 280 predicts the abnormality occurrence timing te of the battery pack 210 on the basis of the time series data of the battery state value received from the VCU 206. The server 280 can give a warning to an operator or a manager of the work machine 100 by outputting the warning information in a stage in which the predicted abnormality occurrence timing te has approached. As a result, the operator or the manager of the work machine 100 can appropriately plan maintenance work such as replacement of the battery pack 210.

The following modifications are also within the scope of the present invention. It is possible to combine a configuration illustrated in a modification and a configuration described in a foregoing embodiment with each other, combine configurations described in the foregoing different embodiments with each other, or combine configurations described in following different modifications with each other.

<First Modification>

For example, a diagnosis execution condition (for example, the voltage variation condition) described in the second embodiment may be included in the diagnosis execution condition in the first embodiment.

In addition, in the foregoing embodiment, described is an example in which the VCU 206 determines whether or not the diagnosis execution condition is satisfied, the VCU 206 computes the battery state value and diagnoses the state of the battery pack 210 on the basis of the computed battery state value when the diagnosis execution condition is satisfied, and the VCU 206 does not diagnose the state of the battery pack 210 on the basis of the battery state value when the diagnosis execution condition is not satisfied. However, the present invention is not limited to this. The processing of determining whether or not the diagnosis execution condition is satisfied may be omitted.

Incidentally, the diagnosis execution condition preferably includes at least one of the temperature condition that is satisfied when the temperatures of the battery cells 212 are equal to or higher than the temperature lower limit value, the temperature variation condition that is satisfied when the difference between the maximum value and the minimum value of the temperatures of the plurality of battery cells 212 is less than the temperature difference upper limit value, the voltage variation condition that is satisfied when the difference between the maximum value and the minimum value of the cell voltages is equal to or smaller than the voltage difference upper limit value, the voltage deviation condition that is satisfied when the difference between the deviation of the minimum value of the cell voltages from the average value and the deviation of the maximum value of the cell voltages from the average value is smaller than the deviation threshold value, and the current condition that is satisfied when the absolute value of the current in the battery cells 212 is equal to or larger than the current lower limit value and equal to or smaller than the current upper limit value. The setting of such a diagnosis execution condition can effectively prevent an erroneous diagnosis from being made.

<Second Modification>

In the foregoing embodiment, described is an example in which the VCU 206 has the battery diagnosing function. However, the present invention is not limited to this. Another controller (for example, the BMU 202) may have a part of the battery diagnosing function. That is, the battery diagnosing function may be implemented by a plurality of controllers.

In addition, the server 280 may have a part or the whole of the battery diagnosing function described in the first embodiment and the second embodiment. For example, the VCU 206 obtains and stores, at each of a plurality of times, the operation data of the battery pack 210 that changes in time series, and transmits the stored operation data to the server 280 via the communicating device 232. The server 280 obtains the operation data of the battery pack 210 from the work machine 100, computes the battery state value on the basis of the obtained operation data, and diagnoses the battery pack 210 on the basis of the computed battery state value.

According to this configuration, the states of the battery packs 210 of a plurality of work machines 100 can be easily managed in the management facility.

<Third Modification>

In the foregoing embodiment, described is an example in which the battery cell 212 is a lithium ion battery. However, the present invention is not limited to this. The battery cell 212 may be a lead storage battery, a nickel metal hydride battery, or the like.

Embodiments of the present invention have been described above. However, the foregoing embodiments merely represent some of examples of application of the present invention and are not intended to limit the technical scope of the present invention to concrete configurations of the foregoing embodiments. For example, the foregoing embodiments are described in detail to describe the present invention in an easily understandable manner, and are not necessarily limited to embodiments including all of the described configurations. In addition, a part of a configuration of a certain embodiment can be replaced with a configuration of another embodiment, and a configuration of another embodiment can be added to a configuration of a certain embodiment. In addition, for a part of a configuration of each embodiment, a configuration of another embodiment can be added, deleted, or substituted.

In addition, a part or the whole of configurations, functions, and the like described above may be implemented as hardware by being designed in an integrated circuit, for example. In addition, configurations, functions, and the like described above may be implemented as software through the interpretation and execution of a program implementing each function by a processor. Information of a program, a table, a file, and the like for implementing each function can be stored in a storage device such as a memory, a hard disk, or an SSD (Solid State Drive) or on a recording medium such as an IC card, an SD card, or a DVD. In addition, control lines and information lines considered to be necessary for description are illustrated, and not all of control lines and information lines in a product are necessarily illustrated. Almost all of configurations may be considered to be actually interconnected.

Description of Reference Characters

100: Work machine
104: Work device
105: Upper swing structure
106: Lower track structure
107: Machine body
200: Battery system
201: Ammeter
203: Charger
204: Electric motor
205: Inverter
206: VCU (controller)
206a: Processing device
206b: Storage device
210: Battery pack (power storage device)
211: Battery module
212: Battery cell (secondary battery cell)
221a: Control lever
221b: Operation sensor
222: Posture sensor
223a: Gate lock lever
223b: Lock lever position sensor
223b: Gate lock lever
230: Battery diagnosis system
231: Display device (output device)
232: Communicating device (output device)
241: Solenoid valve
242: Control valve
243: Hydraulic actuator
280: Server
281: Communication line
282: Communicating device (output device)
283: Display device (output device)

301: Pre-charge voltage storage section
302: Post-charge voltage storage section
303: Pre-discharge voltage storage section
304: Post-discharge voltage storage section
310: Voltage obtainment determining section
311: Diagnosis execution determining section
320: Maximum cell degradation computing section
330: State diagnosing section
Qmin: Minimum cell capacity
Qmin0: Capacity threshold value
Rmax: Maximum cell resistance
Rmax0: Resistance threshold value
Rq: Capacity ratio
Rq0: Capacity ratio threshold value
Rr: Resistance ratio
Rr0: Resistance ratio threshold value

**Claims**

1. A battery diagnosis system comprising:

    a controller configured to obtain operation data of a power storage device including a plurality of secondary battery cells, compute a battery state value on a basis of the obtained operation data, and diagnose a state of the power storage device on a basis of the computed battery state value; and
    an output device that outputs a result of the diagnosis of the power storage device performed by the controller;
    the operation data including a minimum value and a maximum value of cell voltages of the plurality of secondary battery cells constituting the power storage device; and
    the controller being configured to compute a minimum cell capacity or a maximum cell resistance as the battery state value on a basis of the minimum value of the cell voltages measured when a charge/discharge state of the power storage device is a first state and the maximum value of the cell voltages measured when the charge/-discharge state of the power storage device is a second state.

2. The battery diagnosis system according to claim 1, wherein

    the first state is a state before a charge,
    the second state is a state after the charge, and
    the controller is configured to

        compute a minimum value of SOCs on the basis of the minimum value of the cell voltages,
        compute a maximum value of the SOCs on the basis of the maximum value of the cell voltages,
        compute the minimum cell capacity on a basis of a difference between the maximum value and the minimum value of the SOCs and a charging charge amount from the first state to the second state, and
        diagnose the state of the power storage device on a basis of the minimum cell capacity.

3. The battery diagnosis system according to claim 1, wherein

    the first state is a state after a discharge,
    the second state is a state before the discharge, and
    the controller is configured to

        compute a minimum value of SOCs on the basis of the minimum value of the cell voltages,
        compute a maximum value of the SOCs on the basis of the maximum value of the cell voltages,
        compute the minimum cell capacity on a basis of a difference between the maximum value and the minimum value of the SOCs and a discharge charge amount from the second state to the first state, and
        diagnose the state of the power storage device on a basis of the minimum cell capacity.

4. The battery diagnosis system according to claim 1, wherein

the first state is a state before a charge,
the second state is a state during the charge, and
the controller is configured to

compute the maximum cell resistance on a basis of a difference between the minimum value and the maximum value of the cell voltages and a current difference between the first state and the second state, and diagnose the state of the power storage device on a basis of the maximum cell resistance.

5. The battery diagnosis system according to claim 1, wherein

the first state is a state during a discharge,
the second state is a state before the discharge, and
the controller is configured to

compute the maximum cell resistance on a basis of a difference between the maximum value and the minimum value of the cell voltages and a current difference between the second state and the first state, and diagnose the state of the power storage device on a basis of the maximum cell resistance.

6. The battery diagnosis system according to claim 1, wherein
the controller is configured to diagnose the state of the power storage device on a basis of the minimum cell capacity and an average cell capacity.

7. The battery diagnosis system according to claim 1, wherein
the controller is configured to diagnose the state of the power storage device on a basis of the maximum cell resistance and an average cell resistance.

8. The battery diagnosis system according to claim 1, wherein
at least one of the maximum value and the minimum value of the cell voltages used to compute the battery state value is a value measured when a predetermined time has passed in a state in which a current value of a current flowing through the secondary battery cells is equal to or smaller than a predetermined value.

9. The battery diagnosis system according to claim 1, wherein

the controller is configured to

determine whether or not a diagnosis execution condition is satisfied,
diagnose the state of the power storage device on the basis of the battery state value when the diagnosis execution condition is satisfied, and
not diagnose the state of the power storage device on the basis of the battery state value when the diagnosis execution condition is not satisfied, and

the diagnosis execution condition includes at least one of

a temperature condition that is satisfied when temperatures of the secondary battery cells are equal to or higher than a temperature lower limit value,
a temperature variation condition that is satisfied when a difference between a maximum value and a minimum value of the temperatures of the plurality of secondary battery cells is less than a temperature difference upper limit value,
a voltage variation condition that is satisfied when a difference between the maximum value and the minimum value of the cell voltages is equal to or smaller than a voltage difference upper limit value,
a voltage deviation condition that is satisfied when a difference between a deviation of the minimum value of the cell voltages from an average value of the cell voltages and a deviation of the maximum value of the cell voltages from the average value is smaller than a deviation threshold value, and
a current condition that is satisfied when an absolute value of a current in the secondary battery cells is equal to or larger than a current lower limit value and equal to or smaller than a current upper limit value.

10. The battery diagnosis system according to claim 1, comprising:

a server configured to communicate with the controller, wherein
the controller is configured to transmit time series data of the battery state value to the server, and
the server is configured topredict an abnormality occurrence timing of the power storage device on a basis of the time series data of the battery statevalue received from the controller.

FIG. 1

EP 4 502 634 A1

FIG. 2

FIG. 3

CELL VOLTAGE MINIMUM VALUE

CELL VOLTAGE MAXIMUM VALUE

CELL VOLTAGE MAXIMUM VALUE
CELL VOLTAGE MINIMUM VALUE
CELL VOLTAGE AVERAGE VALUE

CURRENT VALUE

SOC

CELL TEMPERATURE MAXIMUM VALUE
CELL TEMPERATURE MINIMUM VALUE
CELL TEMPERATURE AVERAGE VALUE

206

310 VOLTAGE OBTAINMENT DETERMINING SECTION

311 DIAGNOSIS EXECUTION DETERMINING SECTION

301 PRE-CHARGE VOLTAGE STORAGE SECTION

302 POST-CHARGE VOLTAGE STORAGE SECTION

303 PRE-DISCHARGE VOLTAGE STORAGE SECTION

304 POST-DISCHARGE VOLTAGE STORAGE SECTION

320 MAXIMUM CELL DEGRADATION COMPUTING SECTION

330 STATE DIAGNOSING SECTION

EP 4 502 634 A1

FIG. 4

## FIG. 5

START

S500
DETERMINE DATA OBTAINMENT TIMING BEFORE CHARGE
(IS BATTERY PACK IN NO-LOAD STATE?)

S501
OBTAIN CELL VOLTAGE MINIMUM VALUE BEFORE CHARGE

S502
COMPUTE SOCmin1

S503
COMPUTE CHARGING CHARGE AMOUNT ΔQc DURING CHARGE

S504
DETERMINE DATA OBTAINMENT TIMING AFTER CHARGE
(IS BATTERY PACK IN NO-LOAD STATE?)

S505
OBTAIN CELL VOLTAGE MAXIMUM VALUE AFTER CHARGE

S506
COMPUTE SOCmax2

S507
IS DIAGNOSIS EXECUTION
CONDITION SATISFIED?  — No

Yes

S508
COMPUTE SOC MAXIMUM CHANGE AMOUNT ΔSOCmax
COMPUTE MINIMUM CELL CAPACITY Qmin

S509
$Q_{min} < Q_{min0}$ ?  — No

Yes

S510
DETERMINE THAT ABNORMALLY DEGRADED BATTERY CELL
HAS OCCURRED

END

FIG. 6

## FIG. 7

$$\Delta Qc[Ah] = \int I\, dt$$

t1
(BEFORE CHARGE)

t2
(AFTER CHARGE)

FIG. 8

FIG. 9

START

S900 IS TEMPERATURE DIAGNOSIS EXECUTION CONDITION SATISFIED? — No

Yes

S910 IS BATTERY PACK IN NO-LOAD STATE? — No

Yes

S920 IS RESISTANCE DIAGNOSIS PREPARATION FLAG ON? — No

Yes

S911 $Vmax - Vmin \leq Vu0$ ? — No

Yes

S921 $ti \leq ti0$ ? — No

Yes

S930 TURN RESISTANCE DIAGNOSIS PREPARATION FLAG OFF

S912 OBTAIN MAXIMUM VALUE AND MINIMUM VALUE OF CELL VOLTAGES BEFORE DISCHARGE

S922 ARE CURRENT CONDITION AND SOC CONDITION SATISFIED? — No

Yes

S931 COMPUTE MAXIMUM CELL RESISTANCE

S913 TURN RESISTANCE DIAGNOSIS PREPARATION FLAG ON

S923 OBTAIN MAXIMUM VALUE AND MINIMUM VALUE OF CELL VOLTAGES DURING DISCHARGE

S932 $Rmax > Rmax0$ ? — No

Yes

S933 DETERMINE THAT ABNORMALLY DEGRADED BATTERY CELL HAS OCCURRED

END

EP 4 502 634 A1

FIG. 10

## INTERNATIONAL SEARCH REPORT

| International application No. |
|---|
| **PCT/JP2023/005613** |

**A. CLASSIFICATION OF SUBJECT MATTER**

***G01R 31/392***(2019.01)i; ***G01R 31/374***(2019.01)i; ***G01R 31/382***(2019.01)i; ***G01R 31/385***(2019.01)i; ***G01R 31/387***(2019.01)i; ***G01R 31/389***(2019.01)i; ***H01M 10/48***(2006.01)i; ***H02J 7/00***(2006.01)i

FI: G01R31/392; H02J7/00 Y; G01R31/374; G01R31/382; G01R31/385; G01R31/389; G01R31/387; H01M10/48 P

According to International Patent Classification (IPC) or to both national classification and IPC

**B. FIELDS SEARCHED**

Minimum documentation searched (classification system followed by classification symbols)

G01R31/392; G01R31/374; G01R31/382; G01R31/385; G01R31/387; G01R31/389; H01M10/48; H02J7/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2020-169943 A (HITACHI INDUSTRIAL EQUIPMENT SYSTEMS CO., LTD.) 15 October 2020 (2020-10-15) entire text, all drawings | 1-10 |
| A | JP 2018-44927 A (NEC CORP.) 22 March 2018 (2018-03-22) entire text, all drawings | 1-10 |
| A | JP 2010-216914 A (THE TOKYO ELECTRIC POWER CO., INC.) 30 September 2010 (2010-09-30) entire text, all drawings | 1-10 |
| A | JP 2005-114401 A (NISSAN MOTOR CO., LTD.) 28 April 2005 (2005-04-28) entire text, all drawings | 1-10 |

☐ Further documents are listed in the continuation of Box C.    ☑ See patent family annex.

\* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **29 March 2023** | **11 April 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

INTERNATIONAL SEARCH REPORT
Information on patent family members

International application No.

**PCT/JP2023/005613**

| Patent document cited in search report | | | Publication date (day/month/year) | Patent family member(s) | Publication date (day/month/year) |
|---|---|---|---|---|---|
| JP | 2020-169943 | A | 15 October 2020 | (Family: none) | |
| JP | 2018-44927 | A | 22 March 2018 | (Family: none) | |
| JP | 2010-216914 | A | 30 September 2010 | (Family: none) | |
| JP | 2005-114401 | A | 28 April 2005 | (Family: none) | |

Form PCT/ISA/210 (patent family annex) (January 2015)

**REFERENCES CITED IN THE DESCRIPTION**

**Patent documents cited in the description**

- JP 2020169943 A